# EUROPEAN PATENT SPECIFICATION

(11) **EP 4 007 795 B1**
(45) Date of publication and mention of the grant of the patent: **28.08.2024**
(21) Application number: 20848090.5
(22) Date of filing: 30.07.2020
(51) Int. Cl.: C09D 11/106, C09D 11/033, C09D 11/36, C09D 11/037, C09D 11/52

(54) **PRINTABLE MIXTURE, MANUFACTURE, AND USE**
DRUCKBARES GEMISCH, HERSTELLUNG UND VERWENDUNG
MÉLANGE IMPRIMABLE, FABRICATION ET UTILISATION

(30) Priority: 01.08.2019 US 201962881646 P
(43) Date of publication of application: 08.06.2022
(73) Proprietor: University of Massachusetts, Boston, Massachusetts 02108 (US); Raytheon Company, Waltham, MA 02451 (US)
(72) Inventor: RANASINGHA, Oshadha K., Salem, New Hampshire 03079 (US); LUCE, Andrew M., Marlborough, Massachusetts 01752 (US); STRACK, Guinevere M., Hudson, Massachusetts 03051 (US); HAGHZADEH, Mahdi, Lowell, Massachusetts 01854 (US); HARDIE, Cameron, Lowell, Massachusetts 01854 (US); KINGSLEY, Edward, Stow, Massachusetts 01775 (US); ARMIENTO, Craig A., Acton, Massachusetts 01720 (US); AKYURTLU, Alkim, Arlington, Massachusetts 02476 (US)
(74) Representative: Dentons UK and Middle East LLP
(86) International application number: PCT/US2020/044225
(87) International publication number: WO 2021/022024

(56) References cited:
- EP-A1- 3 128 540
- EP-A1- 3 419 028
- WO-A1-2012/165081
- WO-A1-2014/059577
- WO-A1-2016/054484
- WO-A1-2017/127708
- WO-A2-2007/140480
- CN-A- 102 504 646
- CN-A- 107 316 669
- US-A- 3 766 072
- US-A1- 2003 007 050
- US-A1- 2007 283 848
- US-A1- 2017 009 090
- US-A1- 2017 238 425
- US-B2- 9 730 333

## Description

### BACKGROUND

Conventional electronic devices can be printed on a substrate using print techniques as described in U.S. Patent Publication 2017/0009090. For example, this cited patent publication describes a ferroelectric ink comprising Barium Strontium Titanate (BST) in a polymer composite is described. This conventional ink can be employed using direct-ink writing techniques to print high dielectric constant, low loss, and electrostatically-tunable dielectrics on substrates.
WO 2007/140480 A2 discloses printed resistors and processes for forming same. The resistors comprise a conductive phase, preferably comprising conductive nanoparticles, and a resistive phase.

WO 2016/054484 A1 discloses optically transparent films can comprise a coating of nanodiamonds to introduce desirable properties, such as hardness, good thermal conductivity and an increased dielectric constant.

WO 2014/059577 A1 discloses a conductive composition useful for the preparation of electrically conductive structures on a substrate comprising a plurality of metal particles, a plurality of glass particles and a vehicle comprising at least one cellulose derivative and at least one solid organopolysiloxane resin dissolved in a mutual organic solvent.

CN 107 316 669 A discloses a nano-silver coated one-dimensional linear electrode material and a preparation method thereof, pertaining to the technical field of electrode materials.

WO 2012/165081 A1 a condensate which can enhance the tight adhesion between a substrate and an electroconductive pattern formed using an electrocoductive ink, particularly, an ink or paste that contains metal nanoparticles; and a process for manufacturing the same.

EP 3 128 540 A1 discloses a thermosetting resin composition for semiconductor bonding and a thermosetting resin composition for light emitting device which have high thermal conductivity and an excellent heat dissipation property and are capable of reliable pressure-free bonding of a semiconductors element and a light emitting element to a substrate.

EP 3 419 028 A1 discloses a conductive paste of the present invention is excellent in solder heat resistance and adhesion to a substrate. The conductive paste of the present invention comprises (A) a silver powder, (B) a glass frit, (C) an organic binder and an oxide of a platinum group element and/or a compound which can be an oxide of a platinum group element.

WO 2017/127708 A1 discloses a composite waterborne dispersion for 3D printing. The dispersion includes a composition containing an aqueous dispersion of polymer particles; an associative thickener; and a functional filler. The functional filler may be conductive particles, fumed silica, milled glass fibers, polydimethylsiloxane, eutectic metal particles, carbon fiber, thermally insulating
particles, thermally conductive particles, ferromagnetic particles, particles with high acoustic impedance, low-k dielectric particles, or high-k dielectric particles.
The present invention is set forth in the appended set of claims.

### BRIEF DESCRIPTION OF EMBODIMENTS

In contrast to conventional inks, embodiments herein include novel printable formulas/mixtures facilitating the manufacture of different types of electronic devices.

### First Embodiments

More specifically, in one example embodiment, a compound comprises: first particles, the first particles being an insulator material (non-electrically conductive material); second particles, the second particles being electrically conductive material; and a combination of the first particles and the second particles distributed and suspended in a printable material in which a cured state of the printable material is transformable into an electrically conductive path via application of heat above a threshold value, wherein the second particles are silver nanoparticles; wherein the first particles are BST (Barium Strontium Titanate) particles, the compound further comprising at least one solvent.

In accordance with further embodiments, the second particles are fabricated from silver (Ag). In a yet further embodiment, a ratio of the silver particles to the second particles is approximately 62.5 to 37.5 by weight. Additionally, or alternatively, the second particles are so-called Barium Strontium Titanate (BST) particles.

In still further embodiments, a melting point of the second particles is lower than a melting point of the first particles.

A ratio of the first particles to second particles can vary depending on the embodiment. In one embodiment, a ratio of the first particles to the second particles is selected such that a group of the second particles in the cured printable material are substantially isolated from each other (such as not touching either to form a continuous conductive path) prior to application of heat to the group of second particles above a threshold value. Heating regions of the cured printable material above a threshold value causes the second particles to contact each other due to the sintering of silver nanoparticles and form conductive paths.

Further embodiments herein include exposure of the dielectric material (cured printable material) to heat. In one embodiment, exposure of the dielectric layer of material to heat above the threshold value causes contact amongst the second particles in the group due to the sintering (resulting in necking) of the second particles such as silver nanoparticles, the heat converting a portion of the cured printable material into an electrically conductive path.

In accordance with further embodiments, the second particles are silver nanoparticles; the first particles are BST nanoparticles. The compound includes at least one solvent such as 1-methoxy-2-propanol and/or ethylene glycol. In one embodiment, the compound is made up of more than 40% by weight of ethylene glycol.

In yet further embodiments, the first particles make up approximately 12.5% of the compound by weight; the second particles make up approximately 21% of the compound by weight; and the mixture of one or more solvents makes up approximately 66.5% of the compound by weight prior to curing. Subsequent to curing, when the solvents in the printable material evaporate or are removed, the cured printable material comprises between 60-70% of first particles and 30-40% of second particles.

Further embodiments herein include a method comprising: receiving first particles, the first particles being an insulator material; receiving second particles, the second particles being electrically conductive metal material; and suspending a combination of the first particles and the second particles in a printable liquid slurry in which a subsequent cured state of the printable material is transformable into an electrically conductive path via application of heat above a threshold value.

Further embodiments herein include controlling a ratio of mixing the first particles to the second particles in the printable material such that a group of the second particles in a layer of the printable material are isolated from each other (such as non-touching) prior to application of heat to the group of second particles above a threshold value. Subsequent exposure of the printable material to heat above the threshold value causes contact amongst the second particles in the group due to the sintering of silver nanoparticles, the heat converting a portion of the dielectric layer of material into an electrically conductive path. More specifically, the area of the printed layer of dielectric material which was exposed to the heat (such as from a laser or other suitable resource) converts the insulator into the electrically conductive material.

### Second Embodiments

Further embodiments herein include an apparatus comprising: a substrate; printed material disposed on the substrate, the printed material including first particles and second particles, the first particles being an insulator material, the second particles being electrically conductive metal material; and the first particles and second particles being randomly distributed in the printed material, the second particles further being transformable into an electrically conductive path via application of heat above a threshold value.

In accordance with further embodiments, the printed material includes a first portion and a second portion, the first portion of the printed material including second particles that have been sintered (connected) via application of heat, the second portion of the printed material including second particles that have not been sintered via application of heat. In one embodiment, the ink is a homogenous mixture of Ag and BST nanoparticles.

In yet further embodiments, the first portion of the printed cured material has a lower resistivity than the second portion. The BST material is an electrically insulating material.

In still further embodiments, the printed material on the substrate is a dielectric material.

The second particles in the printed material are separated from each other by the first particles prior to application of the heat. In one embodiment, the application of the heat to the group of second particles above the threshold value causes physical contact amongst the group of second particles due to the sintering of silver nanoparticles.

In yet further embodiments, a melting point of the second particles is much lower than a melting point of the first particles.

The second particles can be any suitable metal. In one embodiment, the second particles are silver nanoparticles; the first particles are BST (Barium Strontium Titanate) nanoparticles. The printed material further comprises one or more solvents such as 1-methoxy-2-propanol, ethylene glycol, etc. In one embodiment, the printed material (such as in a non-cured state) is made up of more than 40% by weight of ethylene glycol prior to curing.

In accordance with still further embodiments, the first particles make up approximately 21% of the printed material by weight; the second particles make up approximately 12.5% of the printed material by weight; and the mixture of one or more solvents makes up approximately 66.5% of the printed material by weight.

Further embodiments herein include a method comprising: applying a printable material to a substrate, the printable material including first particles and second particles suspended in the printable material, the first particles being an insulator material, the second particles being electrically conductive metal material; and curing the printable material on the substrate, the second particles in the cured printable material being transformable into an electrically conductive path via application of heat above a threshold value

In accordance with further embodiments, a group of the second particles in the cured printable material are isolated from each other prior to application of heat to the group of second particles above a threshold value.

In one embodiment, the first particles are non-electrically conductive material. The second particles are fabricated from metal.

Further embodiments of the methods herein include: applying heat to the group of second particles disposed in the dielectric layer of material on the substrate, application of the heat to the group causes the group of second particles to form electrically conductive paths on the substrate through the layer of dielectric material. In one embodiment, application of the heat causes sintering (connecting, necking, etc.) of the second particles, resulting in the electrically conductive paths.

As previously discussed, in one embodiment a melting point of the second particles is lower than a melting point of the first particles.

In yet further embodiments, exposure of the dielectric layer of material (cured printable material) to heat above the threshold value causes sintering and/or physical contact amongst the second particles in the group.

In one embodiment, the cured printable material is a dielectric layer of material in which the first particles and the second particles are suspended.

The second particles are any suitable metal such as silver nanoparticles; the first particles are any suitable material such as BST (Barium Strontium Titanate) nanoparticles. The printable material also includes one or more solvents facilitating application of the printable material to a substrate. The one or more solvents can include: 1-methoxy-2-propanol; and ethylene glycol. In one embodiment, the printed material is made up of more than 40% by weight of ethylene glycol prior to curing.

In yet further embodiments, the first particles make up approximately 21% of the printed material by weight; the second particles make up approximately 12.5% of the printed material by weight; and the mixture of one or more solvents makes up approximately 66.5% of the printed material by weight.

Further embodiments herein include a fabricator receiving a substrate. A first layer of dielectric material is disposed on a surface of the substrate. The first layer of dielectric material includes first particles and second particles suspended in the first layer of dielectric material. The first particles comprise insulator material; the second particles are electrically conductive material such as metal. A fabricator applies heat to a region of the first layer of dielectric material; application of the heat transforms a dielectric material in the region of the first layer of dielectric material into an electrically conductive path.

In one embodiment, application of the heat above a threshold value sinters second particles in the region such that they contact each other.

In still further example embodiments, the application of the heat above a threshold value causes a set of the second particles in the region to contact each other, creating the electrically conductive path.

In still further example embodiments, the first layer of dielectric material includes a set of the second particles (electrically conductive material such as metal) in the region, the set of second particles is substantially non-contiguous (non-touching) prior to application of the heat. In such an instance, the second set of second particles provides a high resistance path. The application of the heat above a threshold value causes a sequence of the second particles in the region to electrically contact each other; the contact of the sequence of second particles in the region transforms the region into an electrically conductive path (lower resistance path).

In still further example embodiments, initially, each particle in a group of the second particles in the region are of a first grain size prior to application of the heat. Application of the heat to the region causes the second particles in the group to increase in grain size to a second grain size with respect to the first grain size.

Still further example embodiments include steering a laser beam to the region to heat the region in the first layer of dielectric material. In one embodiment, a fabricator controls a magnitude of the heat applied to the region (such as via any suitable heat resource such as laser, photo lithography, convection oven, etc.) depending on a desired resistance of the electrically conductive path to be produced in the region.

Fabrication as described herein includes creating one or more circuit components. In one embodiment, application of heat to the region of cured dielectric material creates a via extending between a first surface of the first layer of dielectric material and a second surface of the first layer of dielectric material.

Still further embodiments herein include, via a fabricator, applying a second layer of dielectric material on the first layer of dielectric material. Similar to the first layer of dielectric material, the second layer of dielectric material includes first particles and second particles suspended in the second layer of dielectric material. The first particles in the second layer of dielectric material are an insulator material. The second particles in the second layer of dielectric material are electrically conductive material. In a similar manner as previously discussed, the dielectric material is initially a liquid compound (mixture) applied over the first layer of dielectric material to create the second layer of dielectric material. Curing of the material results in the second layer of dielectric material (including the second particles such as metal).

The fabricator applies heat to one or more locations of the second layer of dielectric material. Application of the heat to the second layer of dielectric material transforms the heated portion of dielectric material in the second layer from being and insulator material to being an electrically conductive path. In a manner as previously discussed, an amount of applied heat controls a resistance of the created electrically conductive path in the second layer of dielectric material.

As previously discussed, fabrication of one or more electrically conductive path via application of heat to one or more regions of the cured dielectric material in one or more layers results in creation of an electronic component. Thus, application of heat to one or more region of the one or more layers of dielectric material results in creation of an electronic component.

Note that in accordance with further example embodiments, the dielectric ink such as Ag-BST inks or the like as described herein includes can be used to print resistors on wide range of flexible and rigid substrates.

In one embodiment, the resistors derived from heating the dielectric material are stable between the operating temperatures -50 degree and 150 degree C; the resistance variation is less than 10 % in this temperature range.

In accordance with further example embodiments, application of greater amounts of heat reduces the resistivity of the cured dielectric material (such as cured Ag-BST11 and Ag-BST12 inks) via silver nanoparticles sintering.

In still further example embodiments, Ag-BST13 shows dielectric properties after the curing (exposure to 80 degrees for 15 minutes).

Further heating can be used to convert the cured dielectric material into a conductive material from an insulating material.

In one embodiment, the resistive components as described herein are cured at 250 degree C for 3 hours or more in order to produce stable resistor components.

Heating of one or more regions of the dielectric material can be provided using a conventional box oven, hot plate, laser beam, high intensity broad band light, etc.

The resistivities of all the dielectric inks can be adjusted by changing the heating parameters.

In accordance with further example embodiments, laser sintering can be used to pattern the resistors on cured dielectric material layers; only the laser exposed parts will be conductive and other parts will retain their original dielectric properties.

The resistance of selective laser sintered resistors can be adjusted by changing the laser intensity and laser raster speed.

The selective laser sintering of cured Ag-BST13 layers can be used to fabricate a wide range of devices such as resistors, resistive vias, cylindrical capacitors, vertical parallel plate capacitors, interdigitated capacitors, layers with different sheet resistances, etc.

Embodiments herein are useful over conventional printable ink. For example, the disclosed novel printable ink (such as including a combination of non-conductive particles and conductive particles) can be used in various applications such as those applications implementing dielectric material or resistive material.

As further described herein, different formulas of this disclosed ink can be used in several printing technologies such as dispensing, aerosol jet, inkjet etc.

As previously discussed, substrates coated with a layer of the novel mixture as described herein can be further exposed to heat, which converts the heat-exposed portion of the dielectric layer into a conductive layer. Such an embodiment is useful in fabrication of traces, resistors, etc., on a printed circuit board or other device. These and other more specific embodiments are disclosed in more detail below.

Note that any of the resources as discussed herein such as a fabricator (fabrication facility) can include one or more computerized devices, workstations, handheld or laptop computers, or the like to carry out and/or support any or all of the method operations disclosed herein. In other words, one or more computerized devices or processors can be programmed and/or configured to operate as explained herein to carry out the different embodiments as described herein.

Yet other embodiments herein include software programs to perform the steps and operations summarized above and disclosed in detail below. One such embodiment comprises a computer program product including a non-transitory computer-readable storage medium (i.e., any computer readable hardware storage medium or hardware storage media disparately or co-located) on which software instructions are encoded for subsequent execution. The instructions, when executed in a computerized device (hardware) having a processor, program and/or cause the processor (hardware) to perform the operations disclosed herein. Such arrangements are typically provided as software, code, instructions, and/or other data (e.g., data structures) arranged or encoded on a non-transitory computer readable storage media such as an optical medium (e.g., CD-ROM), floppy disk, hard disk, memory stick, memory device, etc., or other a medium such as firmware in one or more ROM, RAM, PROM, etc., and/or as an Application Specific Integrated Circuit (ASIC), etc. The software or firmware or other such configurations can be installed onto a computerized device to cause the computerized device to perform the techniques explained herein.

Accordingly, embodiments herein are directed to a method, system, computer program product, etc., that supports operations such as fabrication of one or more optical devices as discussed herein.

Further embodiments herein include a computer readable storage media and/or a system having instructions stored thereon to facilitate fabrication of one or more mixtures and corresponding electronic devices as discussed herein. For example, in one embodiment, the instructions, when executed by computer processor hardware, cause the computer processor hardware (such as one or more processor devices) associated with a fabricator to: receive first particles, the first particles being an insulator material; receive second particles, the second particles being electrically conductive metal material; and suspend a combination of the first particles and the second particles in a printable material in which a cured state of the printable material is transformable into an electrically conductive path via application of heat above a threshold value.

In accordance with further embodiments, the instructions, when executed by computer processor hardware, cause the computer processor hardware (such as one or more processor devices) associated with a fabricator to: apply a printable material to a substrate, the printable material including first particles and second particles suspended in the printable material, the first particles being an insulator material, the second particles being electrically conductive metal material; and cure the printable material on the substrate, the second particles in the cured printable material being transformable into an electrically conductive path via application of heat above a threshold value

In accordance with further embodiments, the instructions, when executed by computer processor hardware, cause the computer processor hardware (such as one or more processor devices) associated with a fabricator to: receive a substrate, a first layer of dielectric material disposed on a surface of the substrate, the first layer of dielectric material including first particles and second particles suspended in the first layer of dielectric material, the first particles being an insulator material, the second particles being electrically conductive metal material; and apply heat to a region of the first layer of dielectric material, application of the heat transforming a dielectric material in the region into an electrically conductive path.

The ordering of the steps above has been added for clarity sake. Note that any of the processing steps as discussed herein can be performed in any suitable order.

Other embodiments of the present disclosure include software programs and/or respective hardware to perform any of the method embodiment steps and operations summarized above and disclosed in detail below.

It is to be understood that the method as discussed herein also can be embodied strictly as a software program, firmware, as a hybrid of software, hardware and/or firmware, or as hardware alone such as within a processor (hardware or software), or within an operating system or a within a software application.

Additionally, note that although each of the different features, techniques, configurations, etc., herein may be discussed in different places of this disclosure, it is intended, where suitable, that each of the concepts can optionally be executed independently of each other or in combination with each other. Accordingly, the one or more present inventions as described herein can be embodied and viewed in many different ways.

Also, note that this preliminary discussion of embodiments herein purposefully does not specify every embodiment and/or incrementally novel aspect of the present disclosure or claimed invention(s). Instead, this brief description only presents general embodiments and corresponding points of novelty over conventional techniques. For additional details and/or possible perspectives (permutations) of the invention(s), the reader is directed to the Detailed Description section and corresponding drawings of the present disclosure as further discussed below.

### BRIEF DESCRIPTION OF THE DRAWINGS

FIG. 1 is an example diagram illustrating manufacture of a printable mixture and use of the printable mixture to fabricate electronic devices according to embodiments herein.
FIG. 2 is an example diagram illustrating control information to manufacture a printable mixture according to embodiments herein.
FIG. 3 is an example diagram illustrating control information to manufacture a printable mixture according to embodiments herein.
FIG. 4 is an example diagram illustrating manufacture of a printable mixture and use of the printable mixture to fabricate electronic devices according to embodiments herein.
FIG. 5 is an example graph associated with curing printed dielectric material according to embodiments herein.
FIG. 6 is an example photo illustrating sintered dielectric material versus non-sintered dielectric material according to embodiments herein.
FIG. 7 is an example diagram illustrating fabrication of conductive paths of different widths in dielectric material according to embodiments herein.
FIG. 8 is an example diagram illustrating application of a first magnitude of heat to a layer of dielectric material resulting in fabrication of a corresponding conductive path at a first depth according to embodiments herein.
FIG. 9 is an example diagram illustrating application of a second magnitude of heat to a layer of dielectric material resulting in fabrication of a corresponding conductive path at a second depth according to embodiments herein.
FIG. 10 is an example diagram illustrating application of a third magnitude of heat to a layer of dielectric material resulting in fabrication of a corresponding conductive path at a third depth according to embodiments herein.
FIG. 11A is an example diagram illustrating deposition of a first layer of dielectric material on a substrate according to embodiments herein.
FIG. 11B is an example diagram illustrating application of first heat to the first layer of dielectric material and fabrication of first conductive paths according to embodiments herein.
FIG. 12A is an example diagram illustrating deposition of a second layer of dielectric material over the first layer of dielectric material according to embodiments herein.
FIG. 12B is an example diagram illustrating application of second heat to the second layer of dielectric material and fabrication of second conductive paths according to embodiments herein.
FIG. 13A is an example diagram illustrating deposition of a third layer of dielectric material on a substrate according to embodiments herein.
FIG. 13B is an example diagram illustrating application of third heat to the third layer of dielectric material and fabrication of third conductive paths according to embodiments herein.
FIG. 14 is an example 3D view diagram illustrating a circular capacitor according to embodiments herein.
FIG. 15 is an example side view diagram illustrating a circular capacitor according to embodiments herein.
FIG. 16 is a diagram illustrating example computer architecture to execute one or more operations according to embodiments herein.
FIGS. 17, 18, and 19 are example diagrams illustrating methods according to embodiments herein.

The foregoing and other objects, features, and advantages of the invention will be apparent from the following more particular description of preferred embodiments herein, as illustrated in the accompanying drawings in which like reference characters refer to the same parts throughout the different views. The drawings are not necessarily to scale, with emphasis instead being placed upon illustrating the embodiments, principles, concepts, etc.

### DETAILED DESCRIPTION

Embodiments herein include a printed electronics/additive manufacturing approach to fabricate conductive/resistive features on novel insulating dielectric material such as Silver-Barium Strontium Ttitanate (a.k.a., Ag-BST) printed composite films. For example, a composite functional ink (such as a dielectric liquid ink) as described herein includes a blend of conductive nanoparticle ink and an insulating BST nanoparticle ink. The ratio of metal particles to particles in the final ink is optimized to produce an ink blend that provides an insulating phase after initial curing (such as one or more layers of dielectric material on a substrate) and a conductive/resistive phase following selective laser sintering of the one or more dielectric material layers under ambient conditions.

In one embodiment, selective laser sintered Ag-BST resistor components (as derived from a cured one or more layer of dielectric material) show an ohmic behavior and the resistivity could be adjusted by varying the laser sintering parameters, such as the wavelength, power, and/or the rastering speed/pitch of the laser. This insulator (i.e., initial cured dielectric material layer produced from curing the liquid ink) and conversion of one or more regions of the one or more layers of dielectric material to conductor/resistor regions in the dielectric material provides a new path for direct write printed electronics/additive manufacturing applications. In one nonlimiting example embodiment, thermally sintered Ag-BST resistors showed less than 8 % variation in resistance between -50 °C and 150 °C.

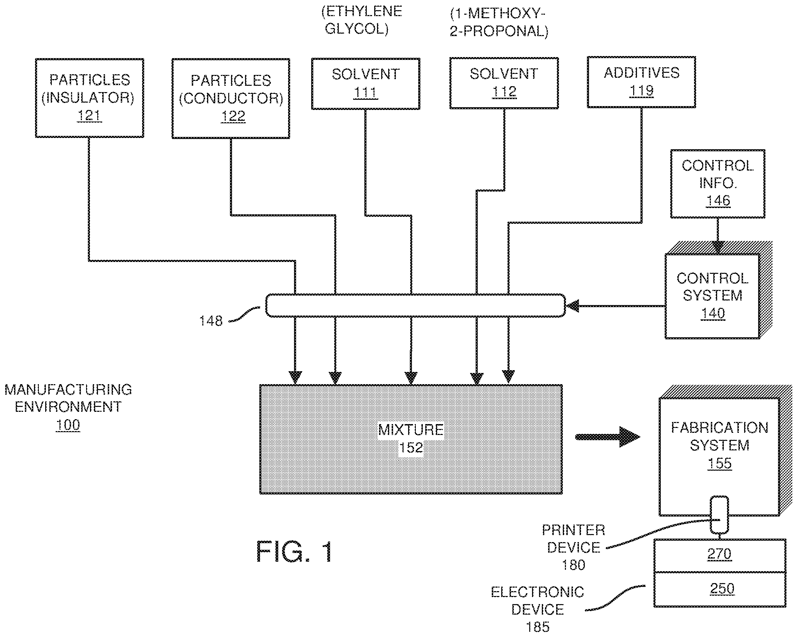

Now, more specifically, with reference to the drawings, FIG. 1 is an example diagram illustrating manufacture of a printable mixture and use of the printable mixture to fabricate electronic devices according to embodiments herein.

As shown, manufacturing environment 100 includes control system 140 and fabrication system 155.

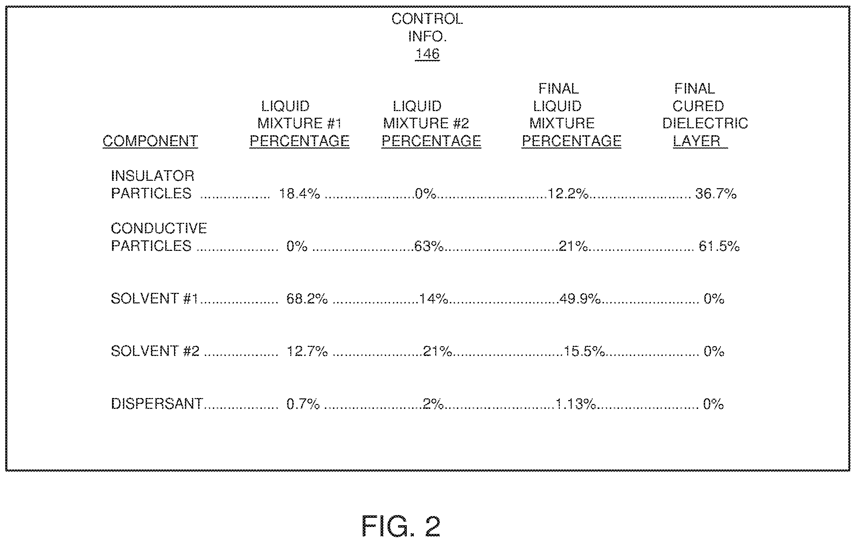

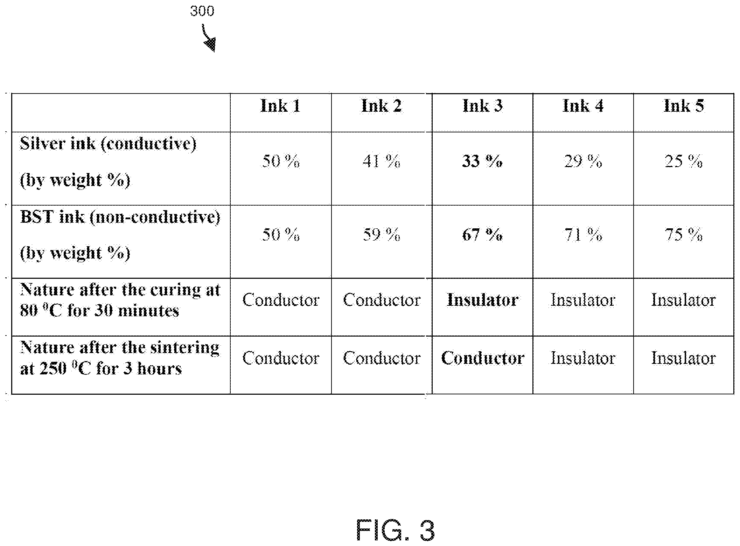

In the fabrication stage of manufacturing environment 100, via control information 146 (see example of component ratios in FIGS. 2 and 3) and control of manufacturing resources 148 (such as valves, conveyors, tubes to deliver material, mixing equipment, agitator equipment, measuring equipment, etc.), the control system 140 produces mixture 152 based on a combination of material such as one or more solvents (liquids) such as solvent 111 (ethylene glycol), solvent 112 (1 methoxy 2 propanol), one or more additives 119 such as dispersant.

As further shown, the control system 140 produces mixture 152 to include particles 121 (insulator particles) and particles 122 (such as conductor particles). Thus, to some extent, the control information 146 includes multiple recipes (ratios of different components) to produce different types of mixtures.

In accordance with further embodiments, the solvent 111 in the mixture 152 (such as printable dielectric ink) is water-soluble. In one embodiment, the solvent 111 is selected from the glycol family of solvents. In a specific embodiment, the solvent 111 is ethylene glycol.

An additive 119 such as dispersant disperses the particles 121 and 122 in the mixture 152. In one embodiment, the dispersant is or includes Ammonium Polymethacrylate (such as a commercial dispersant by the name NanoSperse S ^{™}), which comprises a portion of ammonium polymethacrylate (such as 25% by weight) and a portion of water (such as 75% by weight), although these ratios may vary.

Note that any suitable type of particles can be used to fabricate the mixture 152. For example, in one embodiment, the particles 121 are perovskite oxide particles (such as Barium Strontium Titanate particles or other insulator particles). The particles 121 may be sintered or non-sintered. The particles 122 may be doped.

In accordance with further embodiments, the particles 121 are nanoparticles of uniform shape and size. Alternatively, the mixture may include particles 121 of different sizes and shapes.

According to further embodiments, the particles 121 have a size distribution with a modal size in the range of 30 nanometers to 2000 nanometers, although the mixture may include particles 121 of any suitable size as previously mentioned. The particles 122 have a size distribution with a modal size in the range of 30 nanometers to 2000 nanometers, although the mixture may include particles 122 of any suitable size as previously mentioned.

Note further that the particles 121 can be doped BST particles. Doping can be achieved using any suitable material. In such an instance, the control system 140 produces the pre-mixture 151 to include doped BST nanoparticles.

In accordance with further embodiments, the control system 140 controls a ratio of the one or more solvents (such as solvent 111 and/or solvent 112) and particles 121 and 122, etc., such that the final mixture 152 has a viscosity of between 20 and 6000 cp (CentiPoise). Further embodiments herein include fabricating the mixture (such as dielectric ink) to have viscosities of up to 20,000-25,000 cP. Thus, embodiments herein include controlling ratios of components (such as solvents, particles, etc.) to produce a mixture 152 of desirable viscosity.

As a more specific example in which PVA (Polyvinyl Alcohol) material is absent from the mixture 152, the control system 140 includes solvent 111 such as ethylene glycol and solvent 112 such as 1-methoxy-2-propanol in the mixture 152. The manufacturer controls a viscosity of the mixture 152 based on a ratio of solvent ethylene glycol (having a viscosity of 16 cP) and solvent 1-methoxy-2-propanol (having a viscosity of 1.7 cP) included in the mixture 152.

In one embodiment, the control system 140 controls or adjusts a solvent ratio of these two solvents (such as ethylene glycol and 1-methoxy-2-propanol) in the mixture 152 to obtain a desired viscosity for subsequent fabrication of an electronic device 185.

To produce the final mixture 152 (such as a compound of printable dielectric liquid ink), in accordance with control information 146 (see example of component ratios in FIGS. 2 and 3), the control system 140 combines portions of the pre-mixture 151, solvent 111, and solvent 112.

Note that further embodiments herein include including one or more additives 119 in the mixture 152 to further control its properties. For example, in one embodiment the control system 140 controls inclusion of one or more additives 119 in the mixture 152 (dielectric ink). Available additives 119 include material such as: 1-heptane, alpha-terpineol, ethyl cellulose, glycerol, etc.

Amounts of the additives 119 included in mixture 152 vary depending on the embodiment. In one embodiment, the mixture 152 is fabricated to include up to 5% (such as by weight) of one or more of the additives 119. In other embodiments, the control system 140 produces the mixture 152 such that less than 1% (such as by weight) of the final mixture 152 is made up of one or more additives 119.

As further shown in FIG. 1, fabrication system 155 receives and uses the final mixture 152 to fabricate the electronic device 185. For example, in one embodiment, the fabrication system 155 includes a printer device 180 that control application of the mixture 152 (such as a printable dielectric ink) and, thus, fabrication of the electronic device 185. A heat source (such as oven, hot plate, conveyer belt, etc.) of fabrication system 155 cures the liquid mixture 152 into a solid layer of dielectric material 270. In one embodiment, a hot plate applied to a bottom of the substrate 250 surface heats the liquid mixture 152 to cure it into the layer of dielectric material 270.

As further discussed herein, note that the quantity of components (such as amount/ratio of solvents, particles 130, etc.) can be controlled to facilitate application of the mixture 152 (such as printable ink) in different ways. For example, as further discussed below, different mixtures as described herein can be applied via printer device 180 such as dispensing device, aerosol jet, inkjet, etc., depending on the makeup of the respective mixture 152. Thus, embodiments herein include controlling ratios of material (components) included in the mixture to support different types of printing technology and applications.

Thus, in one example embodiment, a compound mixture 152 comprises: first particles 121, the first particles 121 being an insulator material (non-electrically conductive material); second particles 122, the second particles 122 being electrically conductive material; and a combination of the first particles 121 and the second particles 122 distributed and suspended in a printable material (i.e., mixture 152) in which a cured state (solid of near solid) of the printable material (mixture 152) is transformable into one or more electrically conductive paths via application of heat above a threshold value.

In accordance with further embodiments, the second particles 122 are fabricated from electrically conductive material such as metal. In one embodiment, the particles 122 are silver (Ag) particles. In a yet further embodiment, a ratio of the particles 122 to the particles 121 is approximately 62.5 to 37.5 by weight in the mixture. That is, in one embodiment, 62.5 % (+/- 5%) of all the particles in mixture 152 are particles 122; in one embodiment, 37.5 % (+/- 5%) of all the particles in mixture 152 are particles 121. Additionally, or alternatively, the second particles 122 are Barium Strontium Titanate (BST) particles.

In one embodiment, 62.5 % (+/- 5%) of all the particles in layer of dielectric material 270 (cured mixture 152) are particles 122; in one embodiment, 37.5 % (+/-5%) of all the particles in the layer of dielectric material 270 (cured mixture 152) are particles 121.

In still further embodiments, a melting point of the second particles 122 is lower than a melting point of the first particles 121.

A ratio of the first particles 121 to second particles 122 can vary depending on the embodiment. In one embodiment, a ratio of the first particles 121 to the second particles 122 is selected such that a group of the second particles 122 in the cured printable material (layer of dielectric material 270) are substantially isolated from each other (such as not touching each other so as not to form a continuous conductive path) prior to application of heat to the group of second particles 122 above a threshold value.

As further discussed herein, heating the cured printable material (layer of dielectric material 270 in electronic device 185) to a temperature above a threshold value causes the heated second particles 122 (such as silver or other suitable material) to contact/connect each other due to the sintering of respective particles 122 (such as silver nanoparticles) forming conductive paths.

Further embodiments herein include exposure of the dielectric material (cured printable material) to heat. In one embodiment, exposure of the dielectric layer of material 270 to heat above the threshold value causes contact amongst the second particles 122 in the group due to the sintering of silver nanoparticles; the heat converts a portion of the cured printable material into an electrically conductive path.

In accordance with further embodiments, the second particles 122 are silver nanoparticles; the first particles 121 are BST nano particles. The compound (mixture 152) includes at least one solvent such as 1-methoxy-2-propanol and/or ethylene glycol. In one embodiment, the compound (mixture 152) is made up of more than 40% by weight of ethylene glycol.

In yet further embodiments, the first particles 121 make up approximately 12.5% of the compound (mixture 152) by weight; the second particles 122 make up approximately 21% of the compound (mixture 152) by weight; and the mixture of one or more solvents makes up approximately 66.5% of the compound(mixture 152) by weight prior to curing of the mixture 152 into the layer of dielectric material 270. Subsequent to curing, when the solvents in the printable material evaporate, the cured printable material comprises between 60-70% of first particles and 30-40% of second particles.

Further embodiments herein, via controller 140 and mixing resources 148, include a method comprising: receiving first particles 121, the first particles 121 being an insulator material; receiving second particles 122, the second particles 122 being electrically conductive metal material; and suspending a combination of the first particles 121 and the second particles 122 in a printable liquid slurry (mixture 152) in which a subsequent cured state of the printable material (mixture 152) is transformable into one or more electrically conductive paths via application of heat above a threshold value.

Further embodiments herein include, via controller 140 and the mixing resources 148, controlling a ratio of mixing the first particles 121 to the second particles 122 in the printable material (mixture 152) such that a group of the second particles 122 in a layer of the printable material are isolated from each other (such as non-touching) prior to application of heat to the group of second particles above a threshold value. Subsequent exposure of the cured printable material (layer of dielectric material 270) to heat above the threshold value causes contact amongst the second particles 122 in the group due to the sintering of particles 122, the heat converting a portion of the dielectric layer of material into an electrically conductive path. More specifically, the area of the printed layer which was exposed to the heat (such as from a laser or other suitable resource) will convert the insulator into the electrically conductive path.

FIG. 2 is an example diagram illustrating control information to manufacture a printable mixture according to embodiments herein.

In one embodiment, the control system 140 fabricates the mixture 152 via combining two or more liquid mixtures. For example, in one embodiment, the control system 140 receives and/or produces a first liquid mixture to include 18.4% (by weight) of insulative particles 121, 0 percent (by weight) of conductive particles 122, 68.2 percent (by weight) of solvent #1 (such as ethylene glycol), 12.7 percent of solvent 112 such as 1-methoxy 2-propanol), and 0.7 percent of dispersant.

The control system 140 receives and/or produces a second liquid mixture to include 0.0% (by weight) of insulative particles 121, 63 percent (by weight) of conductive particles 122, 14 percent (by weight) of solvent #1 (such as ethylene glycol), 21.0 percent of solvent 112 such as 1-methoxy 2-propanol), and 2.0 percent of dispersant.

In one embodiment, the control system 140 combines 2 parts of mixture #1 to 1 part of the mixture #2 to produce the liquid (printable) mixture 152. In such an instance, final liquid mixture includes 12.2% (by weight) of insulative particles 121, 21 percent (by weight) of conductive particles 122, 49.9 percent (by weight) of solvent #1 (such as ethylene glycol), 15.5 percent of solvent 112 such as 1-methoxy 2-propanol), and 1.13 percent of dispersant.

Note that the ratio of mixing the first mixture #1 and the second mixture #2 can vary depending on the embodiment. For example, the first liquid mixture #1 can comprise between 28 and 38% percent by weight of the final liquid mixture. The second liquid mixture #2 can comprise between 72 and 62% percent by weight of the final liquid mixture.

In a manner as previously discussed, the final mixture 152 is printable on a respective substrate. After curing, the remaining layer of dielectric material 270 on the substrate 250 comprises 36.7% (by weight) of insulative particles 121, 61.5 percent (by weight) of conductive particles 122, 0 percent (by weight) of solvent #1 (such as ethylene glycol), 0 percent of solvent 112 (such as 1-methoxy 2-propanol), and 0 percent of dispersant. Note that the remaining layer of dielectric material may include some amount of reside material associated with the evaporated material (such as solvents, dispersant, etc.).

### Further Embodiments

In additive manufacturing (a.k.a., AM), printing circuits can be complicated due to the need of multiple types of inks. Usually, two types of functional inks are used to print conductive/resistive parts and insulator/dielectric parts. However, the use of two different functional inks create additional challenges, such as larger device footprint, incompatibility of conductive and dielectric inks, and incompatible curing/sintering procedures. Devices made using AM techniques require dimensional control for device functionality, especially for discrete structures used for applications in the radio (RF) and microwave (MW) frequencies, and higher. Printing capabilities and dimensional control depend on the ink composition and the printing method; therefore, development of functional inks that can be used in printed/additively manufactured devices is a significant and necessary step to advance this technology.

Non-contact direct-write printing technologies such as aerosol jet printers are suited to print fine features as small as 10 µm however, it is necessary to have highly optimized functional inks to achieve consistent printed fine features. Functional inks can be developed and optimized for one or very few printing technologies and for very few substrates due to viscosity and surface energy limitations. Different printing technologies utilize inks of varying viscosities. Therefore, an optimized functional ink for one application cannot be directly used in another application that may needs high precision resolution of printed lines.

For example, printing consecutive resistors and insulators with line widths and separations of less than 50 µm is very challenging when using two different functional inks. The best solution to this problem is to develop a functional ink that can be converted from the insulating phase to the conductive phase by an external stimulation at ambient conditions. Insulator to metal transitions of some materials, such as vanadium oxide, have already been reported. Vanadium oxide can switch between an insulating phase and a metallic phase depending on the operating temperature. However, a functional ink that transitions from an insulator to a conductor phase in unregulated ambient conditions (room temperature such as between 5-40 degree Celsius, atmospheric pressure) has not been reported. Embodiments herein include a functional ink that transitions from an insulator to a conductor phase in ambient conditions (or low temperature curing). For example, embodiments herein include utilizing a laser (or other suitable heat source) to melt/sinter conductive nanoparticles (particles 122) to create conductive paths in a composite nanoparticle film (layer of dielectric material 270) comprised of both conductive (resistive) and non-conductive nanoparticles. This changes three-dimensional physical morphology of the laser exposed areas of composite film without changing the intrinsic properties of either conductive or non-conductive nanoparticles. In order to achieve this, embodiments herein include a novel functional ink (mixture 152) formulated with a blend of conductive and non-conductive nanoparticles. Conductive paths are not formed in the films (one or more layers of dielectric material 270) before the laser sintering to assure that the material is in the insulating state; however, during the laser sintering process in which heat is applied, conductive nanoparticles 122 create conductive paths due to increase of grain sizes and the melting/reflowing of conductive nanoparticles, creating a resistive/conducting material.

Thus, embodiments herein include a novel silver-barium strontium titanate (Ag-BST) composite nanoparticle ink for the additive fabrication of various devices. This Ag-BST composite material is converted from an insulating phase to a conductive phase by the selective laser sintering (SLS) of silver nanoparticles. Moreover, this Ag-BST composite nanoparticle ink can be used as a conventional resistive ink for additive manufacturing and the ink was tested for dispensing printers. Fully thermally sintered resistors showed a less than ± 8 % variation of the resistance between -50 0C and 150 degree C. By way of non-limiting example, these printed resistors can handle up to 1 Watt or more depending on a size of the respective electronic device.

### 2. Materials and Methods

### 2.1 List of materials

In one embodiment, barium strontium titanate (Ba0.67Sr0.33TiO3 - ratio of 2 parts barium to 1 part strontuim to 3 parts titanium to 6 parts oxygen) nanoparticles and ammonium polymethacrylate in water (commercial name - NanoSperse S) are available from TPL Inc., New Mexico, USA. Ethylene glycol (99%) is avail from Fisher Scientific, USA. 1-Methoxy-2-propanol (99.5%) is available from Sigma-Aldrich, USA. Paru MicroPE PG-007 silver nanoparticle ink (~ 63% by weight) is available from Paru Co., Ltd., South Korea. Kapton general purpose polyamide films are available from DuPont, USA.

### 2.2 Ag-BST ink formulation procedure

In one embodiment, the mixture 152 (such as an Ag-BST blended ink) is formulated by blending, via control system 140 and fabrication resources 148, a custom formulated barium strontium titanate (BST) nanoparticle ink (such as mixture #1) and a commercially available PARU silver nanoparticle ink (such as mixture #2). BST nanoparticles (50 wt.%) are added into ethylene glycol and sonicated for 8 hours in the pulse mode (active = 15 seconds, inactive = 59 seconds) using a QSONICA Q500 ultrasonic processor with a 2 mm micro tip. Then, ammonium polymethacrylate in water (~ 2 wt.%) is added into the mixture as a dispersant and sonicated for another 30 minutes in the pulse mode (active = 5 seconds, inactive = 59 seconds) to make a BST slurry. Then, ethylene glycol (~ 49.8 % by weight) and 1-mehtoxy-2-propanol (-12.7 % by weight) are added to the BST nanoparticle 6 slurry and the mixture is magnetically stirred at 400 rpm overnight to get a homogeneous BST nanoparticle ink. Then, different amounts of the BST nanoparticle ink and the silver nanoparticle ink are blended and magnetically stirred overnight to get different Ag-BST ink formulations with different silver nanoparticle loadings.

### 2.3 Ag-BST ink printing and curing procedure

In accordance with further embodiments, the printer device 180 prints the mixture 152 (such as Ag-BST ink) using the Nordson 3-axis automatic dispensing system with a 150 µm tip. In one embodiment, the air pressure is set up to 10 psi (pounds per square inch) to dispense the mixture 152 from a syringe (volume of liquid). In still further example embodiments, the pitch size used is 100 µm during the rastering of large features, which allowed an overlap of the previously printed lines.

The printing speed was changed accordingly to adjust the thickness of the layer. In one embodiment, Kapton polyamide films are used as the substrate 250 for printing the mixture 152. In accordance with further example embodiments, the silver pads for Ag-BST resistors were printed using the same dispensing system with a 100 µm tip. The silver pads were printed and cured at 250 0C in vacuum oven for 3 hours before printing the Ag-BST ink between the silver pads. The printed Ag-BST features were initially cured at 80 degree C for 30 minutes on a hotplate before laser sintering.

### 2.3 SLS of Ag-BST

After the initial curing of the fabricated mixture 152 on substrate 250, the corresponding electronic device 185 is exposed to 80 degree C temperature for 30 minutes. Then, SLS allows fabrication of customized conductive patterns at room temperature to be created and the resistances of the patterns can be adjusted by changing the laser sintering parameters. In one embodiment, the laser material is laser sintered via an 830 nm (nanometer) continuous wave (CW) laser in an Optomec AJ5X aerosol jet printer. The approximate laser spot size was around 70 µm in diameter, which was measured using a photo paper. Nitrogen gas is used as a shield gas for the laser to prevent the oxidation of the silver nanoparticles during laser sintering.

The laser power, rastering pitch, and rastering speed associated with the signal 231 (fabrication signal such as optical signal or optical pulses, convection signal, radiation signal, etc.) can be adjusted to produce electronic devices having a range of resistivities. In addition, note that the 405 nm continuous wave (CW) laser in the Heidelberg µPG 101 laser writer with a laser spot size of 2 µm was used to selectively laser sinter high precision conductive patterns and the laser power and the rastering speed were adjusted in order to get different resistivities.

### 2.4 Characterization techniques

In accordance with further example embodiments, an Agilent Cary 8454 UV/Vis/NIR Spectrophotometer was used for UV-Vis absorption measurements of liquid inks. A Keyence VHX-5000 digital microscope was used for the initial investigation of the cracks after the curing. TA instruments ARES-G2 rheometer was used to measure the viscosities of the inks. Ink samples were loaded in a 400 mm diameter, 0.04 rad stainless-steel cone and plate geometry. Flow sweeps from 1 s-1 to 100 s-1 were recorded at 25 oC using an Advanced Peltier System for temperature control. Raman scattering spectra were obtained using a Raman microscope (Senterra II; Bruker) with a 532 nm laser, a power of 2 mW, an integration time of 1 second, and two co-additions; mapping was carried out by obtaining 300 to 330 spectra in a grid pattern spaced at least 10 µm apart. The resistors were probed using the DC needles of an MPI TS2000-SE probe station with an ERS thermal chuck. Keithley 4200 semiconductor parametric analyzer was used to record the current-voltage curves for laser and thermally sintered Ag-BST resistors. The voltage was swept from -1 V to +1 V. The resistance was calculated using the slope of the current vs voltage line. Sheet resistances were measured using the Pro4-4400 Four Point Resistivity System (Signatone) measurement system. The scanning electron microscopy images were obtained using a Zeiss Auriga Focused Ion Beam-Scanning Electron Microscope (FIB-SEM), which was operated at 5 keV. A gallium liquid metal ion source at 30 kV and 50 pA was used for FIB milling to investigate the cross sections of the printed features.

### 3. Results and Discussion

### 3.1 Ag-BST blended ink formulation

In accordance with further example embodiments, the mixture 152 is a silver-barium strontium titanate (Ag-BST) blended ink, which can convert printed Ag-BST layers from an insulating phase to a conductive phase by the SLS of silver nanoparticles. SLS can be used to make customized conductive patterns on initially cured (insulating phase) Ag-BST layers. Ag and BST were identified as the candidate conductive and nonconductive materials due to the following reasons. Silver has the highest conductivity of bulk materials and Ag nanoparticles are widely used in conductive inks for printed electronics. In addition, silver nanoparticles can be sintered at lower temperatures due to the melting point depression and compatibility with sintering techniques such as laser, photonic, and chemical sintering. Barium strontium titanate was used as the non-conductive material because of its appropriate dielectric properties (high dielectric constant and low loss tangent) for RF and microwave applications, high melting point (over 1000 degree C), high dielectric breakdown voltage and the minimal interaction with silver nanoparticles. Even though investigating the dielectric properties of Ag-BST at the insulating phase is not in the scope of this work, dielectric properties of BST will be useful to fabricate selective laser-sintered RF and microwave devices on Ag-BST.

Embodiments herein a correct blending ratio of the conductive material (particles 122) and the non-conductive material (particles 121) to ensure the cured material (layer of dielectric material 270) is insulating after the initial curing of same. Portions of the layer of dielectric material 270 are conductive after application of sufficient heat.

In one embodiment, in order to find the correct blending ratio, a series of blended Ag-BST ink samples were prepared. The table 300 in FIG. 3 shows the blending composition of the 5 different Ag-BST inks along with the conditions of the inks after the initial curing and thermal sintering. The composition of silver and BST nanoparticles after the thermal sintering can be found in the supplementary information. The amount of BST was increased in the blended ink samples until the insulating phase of the printed samples was achieved after the initial curing. A 10 by 10 mm features of each ink sample was printed on Kapton substrates using the dispensing printer, followed by the initial curing at 80 °C for 30 minutes. Inks 1 and 2 showed conductivity after the initial curing and ink 3, 4 and 5 showed an insulating phase after the initial curing procedure. Then thermal sintering was performed at 250 °C for 3 hours in a vacuum oven to find the final resistivity of each Ag-BST ink sample.

With respect to table 300 in FIG. 3, inks 1 and 2 showed a decrease in the resistivity after thermal sintering (data not shown). Ink 3 transitioned to the conductive phase from the insulator phase after the completion of thermal sintering. Ink 3 shows around 329 times higher resistivity compared to the pure silver ink; therefore, it can be used as a conventional resistive ink to print resistors. Inks 4 and 5 did not show any conductivity even after the thermal sintering. It was deduced that inks 4 and 5 did not have enough silver nanoparticles to create conductive paths during the sintering process. Therefore, the blending ratio of ink 3 (such as mixture 152) was concluded as the optimized ratio for the Ag-BST insulator to conductor conversion and all further experiments were conducted with the Ag-BST ink 3. The Ag-BST ink which shows the conversion from the insulating phase to the conductive phase consists of approximately 67 % (+/- 5%) by weight of the BST nanoparticle ink and 33% (+/- 5%) by weight of the silver nanoparticle ink.

In one embodiment, the dynamic viscosity of the mixture 152 was relatively constant over the tested shear rates, which indicates that the blended ink is stable without large agglomerated nanoparticles clusters. Larger agglomerated nanoclusters degrade the printing quality, decrease the adhesion, and result in high surface roughness. UV-Visible absorption spectra for the silver ink, BST ink and the Ag-BST ink can be seen in supplementary information. The absorption maximum of the Ag-BST ink is located around 430 nm and it can be assigned to the surface plasmon resonance frequency of silver nanoparticles.

### 3.2 SLS of Ag-BST blended ink

SLS is a commonly used technique in additive manufacturing to sinter/melt powdered materials using high power lasers to create 3D objects. However, according to embodiments herein, SLS was used to create conductive patterns on Ag-BST insulating films. Dispensing, spin coating and doctor blading can be used to deposit Ag-BST blended ink and all the Ag-BST films for this work were printed using the Nordson automatic dispensing system. The printed Ag-BST wet films were cured at 80 °C for 30 minutes to evaporate the solvents and other ink additives. No conductivity was observed after the initial curing due to the homogeneously distributed of separated silver nanoparticles, confirming the insulating phase of the ink. Then, this insulating Ag-BST film was exposed to the programable laser to pattern

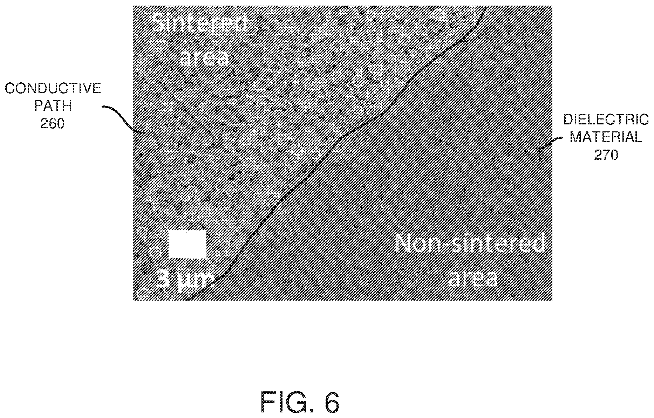

According to the proposed sintering mechanism (such as application of heat) as described herein, silver nanoparticles (particles 122) are sintered under the laser heat exposure and create conductive paths due to increase in the grain size of particles 122 and the reflowing of melted particles 122 (such as silver nanoparticles). The surface morphology changes due to the laser sintering are shown in FIG. 6. However, BST nanoparticles (particles 122) remain unchanged due to the high melting point and the higher bandgap.

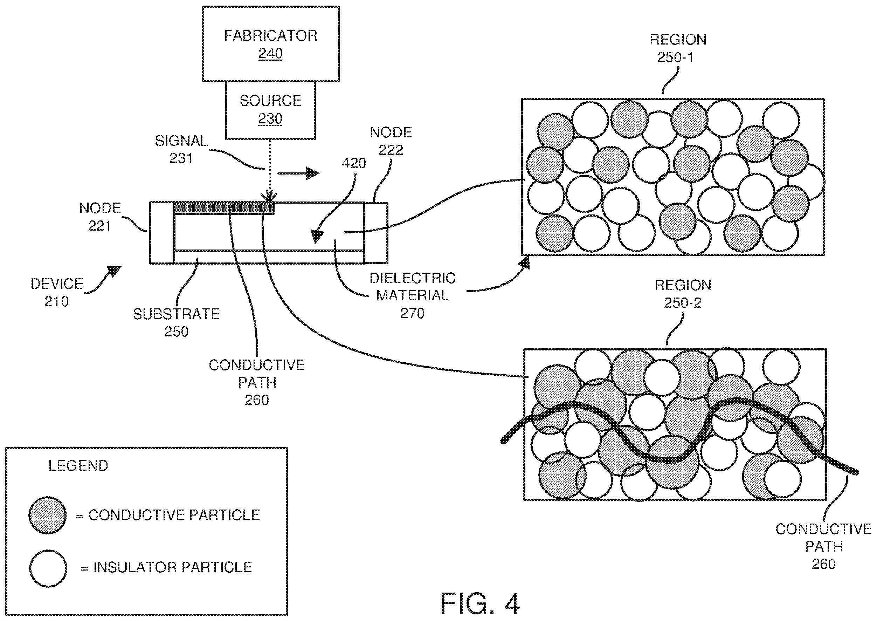

In one embodiment, selective laser-sintered resistors are fabricated between two silver printed contact pads, which were used to probe the resistors to measure the resistance. The selective laser-sintered resistors are clearly visible due to the color change because of the sintering of Ag nanoparticles. The resistivity of the laser-sintered particles 122 (such as Ag-BST) depends on the laser sintering parameters such as wavelength, power, rastering speed and the rastering pitch. Embodiments herein include use of an 830 nm inbuilt continuous wave (CW) laser in the Optomec AJ5X aerosol jet printer. In addition, 405 nm CW laser of the Heidelberg µPG 101 laser writer can be used to laser sinter the layer of dielectric material 270. FIG. 4 is an example diagram illustrating creation of conductive paths on a printed layer of dielectric material 270 as further discussed below.

Raman spectra were used to investigate the sintering mechanism of the Ag-BST resistors. Surface-enhanced Raman scattering (SERS) takes place on the surface of some metallic nanostructures and is caused by the local excitation of surface plasmons. This technique allows for the detection of low concentrations of organic molecules located on the surface of silver nanoparticles. SERS was used to assess the laser-sintered surface of the Ag-BST films. Initial investigations indicated that the regions not exposed to the laser produced Raman spectra with peaks associated with residual organic molecules. The peaks varied with each spectrum, and therefore, were not used to identify the composition of the residual organic molecules. According to Figure 4, three major regions (non-laser-sintered, transition, and laser-sintered) were identified by integrating the averaged amorphous carbon peaks located between 1000 and 1800 cm-1.The relatively high intensity peak found in the transition region can be attributed to the incomplete decomposition of organic molecules caused by heat diffusion from the laser-sintered region. The laser-sintered area did not show a significant amount of scattering associated with amorphous carbon, which indicates the decomposition of organic residuals; however, it is not clear if the lack of peaks associated with Raman scattering is due to the complete removal of organic compounds or a decrease in the enhancement factor that is caused by particle sintering and enlarging.

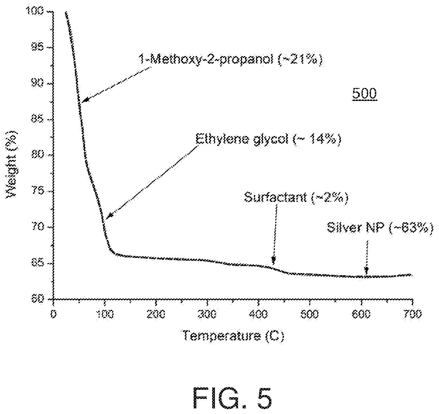

In addition to the 830 nm CW laser inbuilt in the Optomec AJ5X aerosol jet printer, 405 nm CW laser of the Heidelberg µPG 101 laser writer was used to laser sinter fine features. Figure 5a shows the laser-sintered Ag-BST resistors with laser-sintered contact pads for probing. The resistors showed a 12.1 kΩ (6 mm of length) and the line width was around 25 µm. The linewidth was consistent for all 5 laser-sintered resistors which confirmed the ability of laser sintering to produce precise fine features. Also, cleaner edges (low edge roughness) were observed compared to printed resistors. Please see the supplementary information (ESI Figure S12) for the SEM images of the edges of the laser-sintered resistors. The SEM images in Figures 5b and 5c show the surface morphology of the Ag-BST film before and after laser sintering. The increase in the grain size of Ag nanoparticles can be observed after the laser sintering and some of the grains are over 1 µm in diameter. The efficient sintering of Ag nanoparticles can be attributed to the localized plasmonic heating effects of the Ag nanoparticles. Ag-BST shows the maximum absorption with a broad peak around 430 nm due to the surface plasmon resonance of Ag nanoparticles. This broad peak conveniently resonates with the 405 nm laser, which generates local heating and leads to the efficient sintering of Ag nanoparticles. Lasers which have wavelengths away from the absorption maximum of the Ag nanoparticles need to use a higher power for sintering due to the lack of localized plasmonic heating.

### 3.3 Thermally sintered Ag-BST resistors

In addition to patterning the conductive traces by SLS, Ag-BST blended ink can be used as a conventional resistive ink for additive manufacturing/printed electronics. This Ag-BST blended ink is optimized for the Nordson automatic dispensing printer and suitable to print resistive features with a linewidth higher than 100 µm. The line resistors were printed with silver pads for probing to test the temperature stability of the thermally sintered resistors. Printed resistors were thermally sintered at 250 °C for 3 hours under vacuum in a box oven.

In yet further example embodiments, the component in the mixture 152 of Ag-BST13 before the curing:
1. Silver nanoparticles = 21 % by weight
2. BST nanoparticles = 12.5 % by weight
3. Ethylene glycol = 51 % by weight
4. 1-Methoxy-2-Propanol = 15.5 % by weight
The component of Ag-BST13 after the curing (i.e., dielectric material 270) in which Ethylene glycol and 1-Methoxy-2-Propanol are evaporated from the mixture 152 is:
1. Silver (metal) nanoparticles = 62.5 % (or in the range 55% to 70%) by weight
2. BST nanoparticles = 37.5 % (or in the range 30% to 45%) by weight

In one embodiment, as previously discussed, the Ethylene glycol and 1-Methoxy-2-Propanol evaporates during the curing process such that the remaining layer of dielectric material 270 is a solid compound of metal particles and insulator particles.

FIG. 4 is an example diagram illustrating transformation of dielectric material into a conductive path according to embodiments herein.

In this example embodiment, the fabricator 240 fabricates a respective resistor (device 210) between node 221 and node 222. As previously discussed, the fabricator 240 disposes the dielectric material 270 over the substrate 250. After curing, the fabricator 240 controls the source 230 (such as laser) to produce the signal 231 (such as optical signal, convection signal, etc.) applied to the layer of dielectric material 270. The layer of dielectric material 270 includes region 250-1 (cured mixture 152) in which the insulator particles 121 (interlaced with particles 122) generally prevent the particles 122 from forming a respective low resistance path between the node 221 and the node 222.

Via application of the signal 231 (such as optical or laser signal at any suitable wavelength such as 405 nanometers, 830 nanometers, etc.), the fabricator 250 converts the dielectric material 270 into a respective conductive path 260. As shown in region 250-2, the dielectric material is converted into a conductive path 260 via the sequential contacting of the (metal) particles 122 to each other to form a low impedance path. As previously discussed, application of signal 231 causes reflow/sintering as well as connectivity of the particles 122. In one embodiment, the particles 122 contact each other via necking, sintering, etc.

FIG. 5 is an example graph associated with curing of the printed dielectric material according to embodiments herein.

As shown, the weight of the mixture 152 changes as it is exposed to heat during curing. For example, exposure of the mixture 152 to a temperature of gretaer than 20 and less than 150 degree Celsius causes the 1-methoxy 2-propanol and ethylene glycol to be evaporated from the mixture 152. Between 100 and 200 degrees Celsius, the amounts of surfactant associated with the layer of diametric material 270 decreases.

FIG. 6 is an example photo illustrating sintered dielectric material versus non-sintered dielectric material according to embodiments herein.

As previously discussed, the fabricator applies heat to a portion of the cured mixture (layer of dielectric material) resulting in creation of conductive path 260 in dielectric material 270.

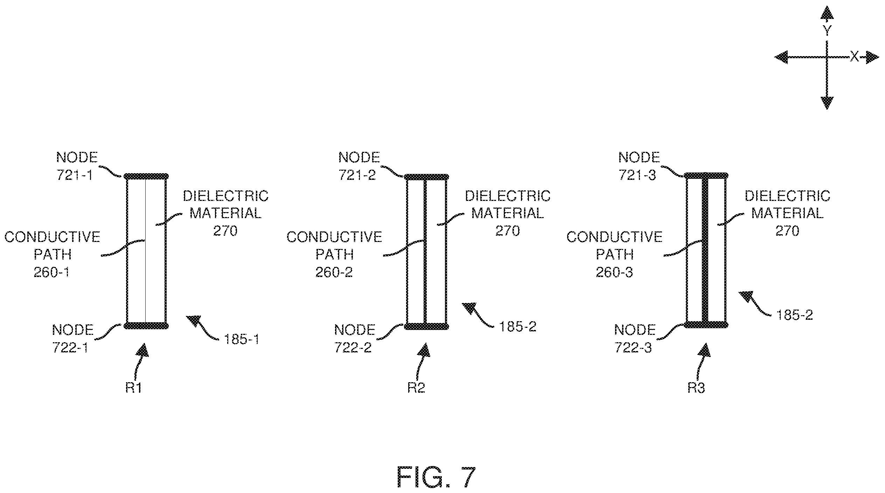

FIG. 7 is an example diagram illustrating fabrication of different width of conductive paths in dielectric material forming different resistor values according to embodiments herein.

In this example embodiment, the fabricator 240 fabricates the electronic device 185-1 (such as resistor R1) to include conductive path 260-1 in dielectric material 270 along the Y-axis via application of a first laser beam (which is orthogonal to the x-axis and y-axis) between the node 721-1 and the node 722-1. A width of the conductive path 260-1 as measured in the x-axis dictates a resistance of the electronic device 185-1 (resistor R1).

The fabricator 240 fabricates the electronic device 185-2 (such as resistor R2) to include conductive path 260-2 in dielectric material 270 along the Y-axis via application of a second laser beam (which is orthogonal to the x-axis and y-axis) between the node 721-2 and the node 722-2. A width of the conductive path 260-2 as measured in the x-axis dictates a resistance of the electronic device 185-1 (resistor R2).

The fabricator 240 fabricates the electronic device 185-3 (such as resistor R3) to include conductive path 260-3 in dielectric material 270 along the Y-axis via application of a second laser beam (which is orthogonal to the x-axis and y-axis) between the node 721-3 and the node 722-3. A width of the conductive path 260-3 as measured in the x-axis dictates a resistance of the electronic device 185-3 (resistor R3).

In this example embodiment, assume that each of the conductive paths 260 is the same depth in the z-axis. In such an instance, the wider the (electrically) conductive path 260, the lower the resistance. For example, the magnitude of the resistor R3 is less than the magnitude of the resistor R2; the magnitude of the resistor R2 is less than the magnitude of the resistor R1.

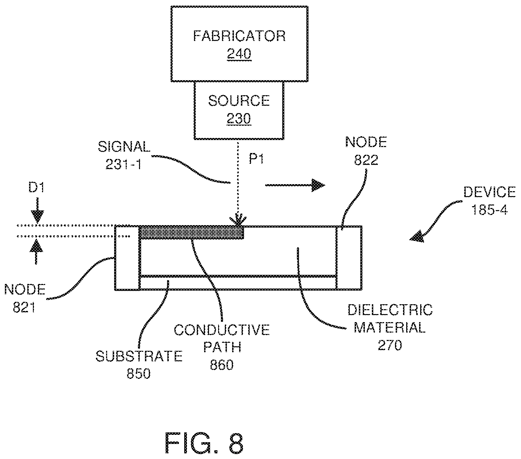

As further discussed herein, a depth of the respective conductive path fabricated in the layer of dielectric material 270 can vary depending on an amount of heat associated with signal 231-1 as shown in FIGS. 8, 9, and 10.

More specifically, FIG. 8 is an example diagram illustrating application of a first magnitude of heat to a layer of dielectric material resulting in fabrication of a corresponding conductive path at a first depth according to embodiments herein.

As shown in this example embodiment, the fabricator 240 controls source 230, which applies signal 231-1 at power level P1 to the dielectric material 270 on substrate 850 of the electronic device 185-4. Application of the signal 231-1 results in generation of the conductive path 860 having depth D1. The deeper the conductive path in the dielectric material 270, the lower the resistance.

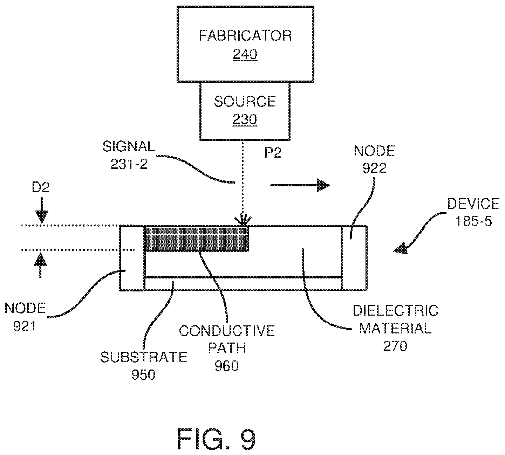

FIG. 9 is an example diagram illustrating application of a second magnitude of heat to a layer of dielectric material resulting in fabrication of a corresponding conductive path at a second depth according to embodiments herein.

As shown in this example embodiment, the fabricator 240 controls source 230, which applies signal 231-2 at power level P2 to the dielectric material 270 on substrate 950 of the electronic device 185-4. Application of the signal 231-1 results in generation of the conductive path 960 having depth D1. The deeper the conductive path in the dielectric material 270, the lower the resistance. Accordingly, the resistance of the conductive path 960 is less than the resistance of the conductive path 860.

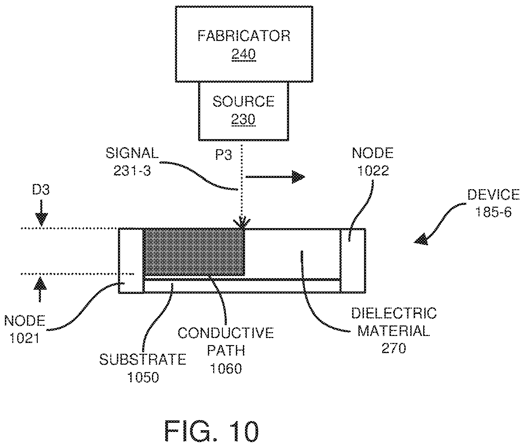

FIG. 10 is an example diagram illustrating application of a third magnitude of heat to a layer of dielectric material resulting in fabrication of a corresponding conductive path at a third depth according to embodiments herein.

As shown in this example embodiment, the fabricator 240 controls source 230, which applies signal 231-3 at power level P3 to the dielectric material 270 on substrate 850 of the electronic device 185-4. Application of the signal 231-1 results in generation of the conductive path 860 having depth D1. The deeper the conductive path in the dielectric material 270, the lower the resistance. Accordingly, the resistance of the conductive path 1060 is less than the resistance of the conductive path 960.

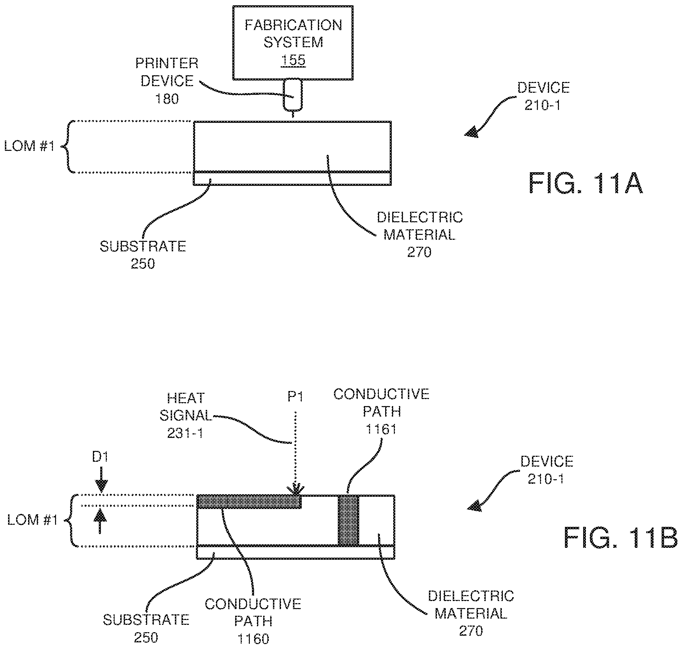

The combination of FIGS. 11A, 11B, 12A, 12B, 13A, and 13B illustrate 3-dimensional fabrication of a respective electronic device according to embodiments herein.

FIG. 11A is an example diagram illustrating deposition of a first layer of dielectric material on a substrate according to embodiments herein.

As shown in FIG. 11A, the fabrication system 155 applies and cures layer of dielectric material 270 (a.k.a., layer #1) on the substrate 250 in a manner as previously discussed.

FIG. 11B is an example diagram illustrating application of first heat to the first layer of dielectric material and fabrication of first conductive paths according to embodiments herein.

As shown in FIG. 11B, the fabricator 240 applies signal 231-1 to the dielectric material 270 in layer #1 to create conductive path 1160 and conductive path 1161 (such as a via). In one embodiment, via application of sufficient heat, the conductive path 1161 extends between a top surface of the layer #1 and the bottom surface of the layer #1. Accordingly, the conductive path 1161 provides connectivity between layers.

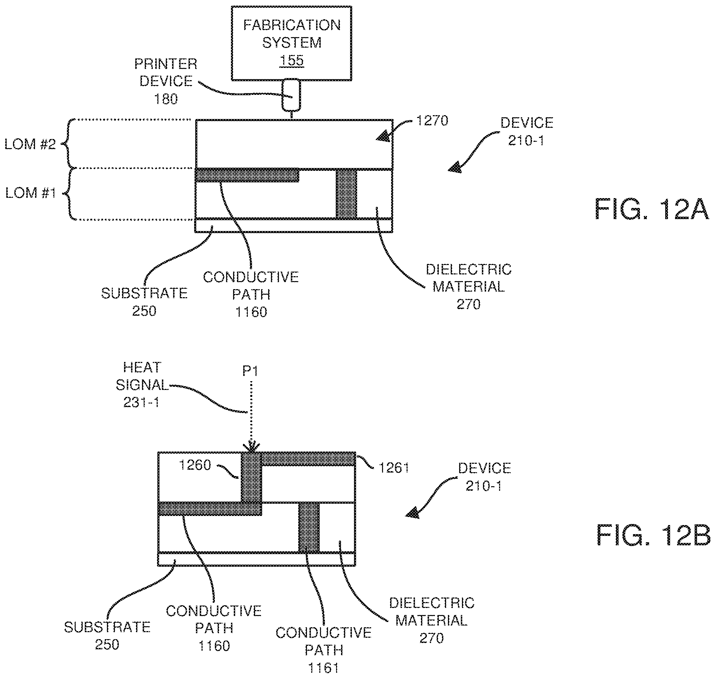

FIG. 12A is an example diagram illustrating deposition of a second layer of dielectric material over the first layer of dielectric material according to embodiments herein.

As shown in FIG. 12A, the fabrication system 155 applies and cures (via exposure to heat) a second layer of dielectric material 270 (a.k.a., layer #2) on the layer #1.

FIG. 12B is an example diagram illustrating application of second heat to the second layer of dielectric material and fabrication of second conductive paths according to embodiments herein.

As shown in FIG. 12B, the fabricator 240 applies signal 231-1 to the dielectric material 270 in layer #2 to create conductive path 1260 (such as a via) and conductive path 1261. In one embodiment, via application of sufficient heat, the conductive path 1260 extends between a top surface of the layer #2 and the bottom surface of the layer #2 to conductive path 1160.

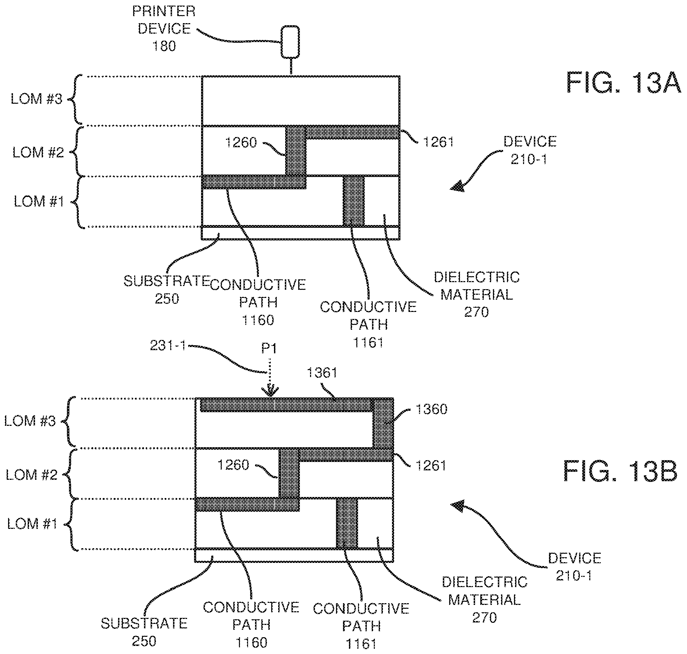

FIG. 13A is an example diagram illustrating deposition of a third layer of dielectric material on a substrate according to embodiments herein.

As shown in FIG. 13A, the fabrication system 155 applies and cures a third layer of dielectric material 270 (a.k.a., layer #3) on the layer #2 of dielectric material 270.

FIG. 13B is an example diagram illustrating application of third heat to the third layer of dielectric material and fabrication of third conductive paths according to embodiments herein.

As shown in FIG. 13B, the fabricator 240 applies signal 231-1 to the dielectric material 270 in layer #3 to create conductive path 1360 (such as a via) and conductive path 1361. In one embodiment, via application of sufficient heat, the conductive path 1360 extends between a top surface of the layer #3 and the bottom surface of the layer #3 to conductive path 1261.

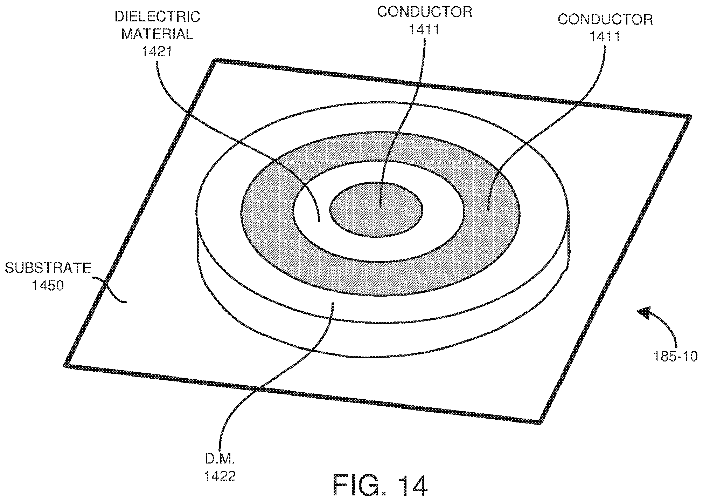

FIG. 14 is an example 3D view diagram illustrating an electronic device according to embodiments herein.

In this example embodiment, a layer of dielectric material is deposited on a surface of the substrate 1450 (such as an insulator material, flexible or rigid). The fabricator applies heat to the layer of dielectric material to produce the conductor 1411 (first electrode of the electronic device 185-10) and conductor 1412 (second electrode of the electronic device 185-10). Dielectric material 1421 is disposed between conductor 1411 and conductor 1412.

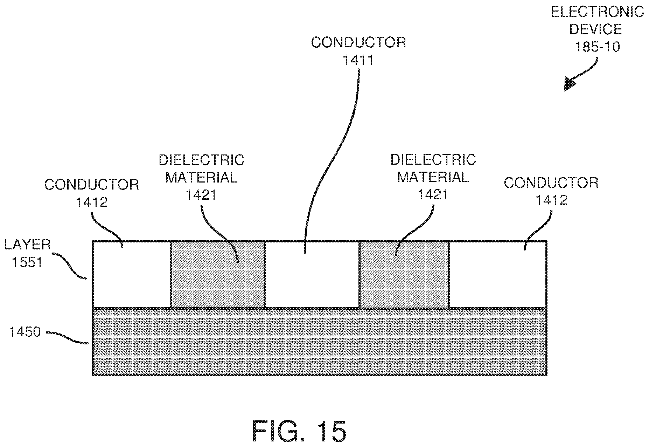

FIG. 15 is an example side view diagram of the electronic device 185-10 (such as cylindrical capacitor) according to embodiments herein.

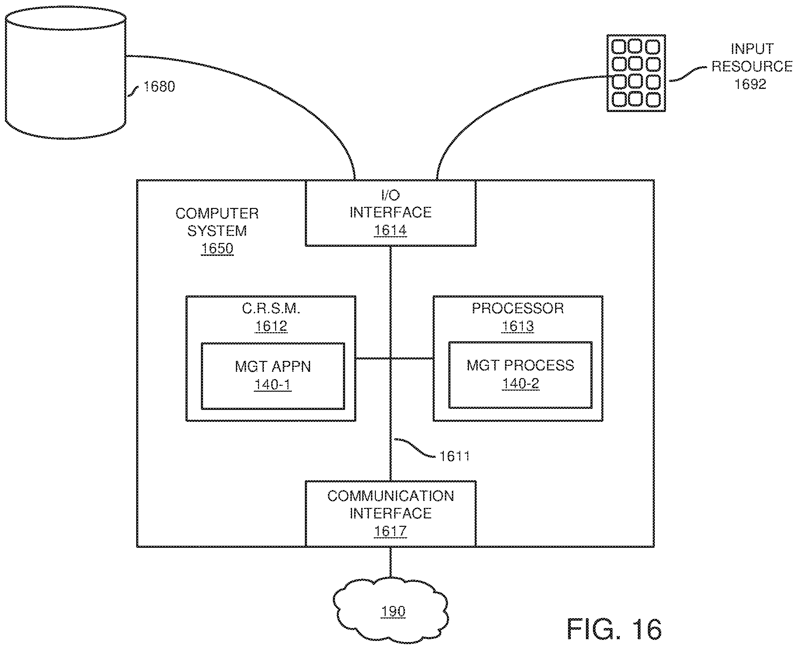

FIG. 16 is an example block diagram of a computer system for implementing any of the operations as previously discussed according to embodiments herein.

Any of the resources (such as mobile communication devices, wireless access points, wireless stations, wireless base stations, communication management resource, bandwidth management resource, etc.) as discussed herein can be configured to include computer processor hardware and/or corresponding executable instructions to carry out the different operations as discussed herein.

As shown, computer system 1650 of the present example includes an interconnect 1611 coupling computer readable storage media 1612 such as a non-transitory type of media (which can be any suitable type of hardware storage medium in which digital information can be stored and retrieved), a processor 1613 (computer processor hardware), I/O interface 1614, and a communications interface 1617.

I/O interface(s) 1614 supports connectivity to repository 1680 and input resource 1692.

Computer readable storage medium 1612 can be any hardware storage device such as memory, optical storage, hard drive, floppy disk, etc. In one embodiment, the computer readable storage medium 1612 stores instructions and/or data.

As shown, computer readable storage media 1612 can be encoded with management application 140-1 (e.g., including instructions) to carry out any of the operations as discussed herein.

During operation of one embodiment, processor 1613 accesses computer readable storage media 1612 via the use of interconnect 1611 in order to launch, run, execute, interpret or otherwise perform the instructions in management application 140-1 stored on computer readable storage medium 1612. Execution of the management application 140-1 produces management process 140-2 to carry out any of the fabrication operations and/or processes as discussed herein.

Those skilled in the art will understand that the computer system 1650 can include other processes and/or software and hardware components, such as an operating system that controls allocation and use of hardware resources to execute management application 140-1.

In accordance with different embodiments, note that computer system may reside in any of various types of devices, including, but not limited to, a mobile computer, a personal computer system, wireless station, connection management resource, a wireless device, a wireless access point, a base station, phone device, desktop computer, laptop, notebook, netbook computer, mainframe computer system, handheld computer, workstation, network computer, application server, storage device, a consumer electronics device such as a camera, camcorder, set top box, mobile device, video game console, handheld video game device, a peripheral device such as a switch, modem, router, set-top box, content management device, handheld remote control device, any type of computing or electronic device, etc. The computer system 1650 may reside at any location or can be included in any suitable resource in any network environment to implement functionality as discussed herein.

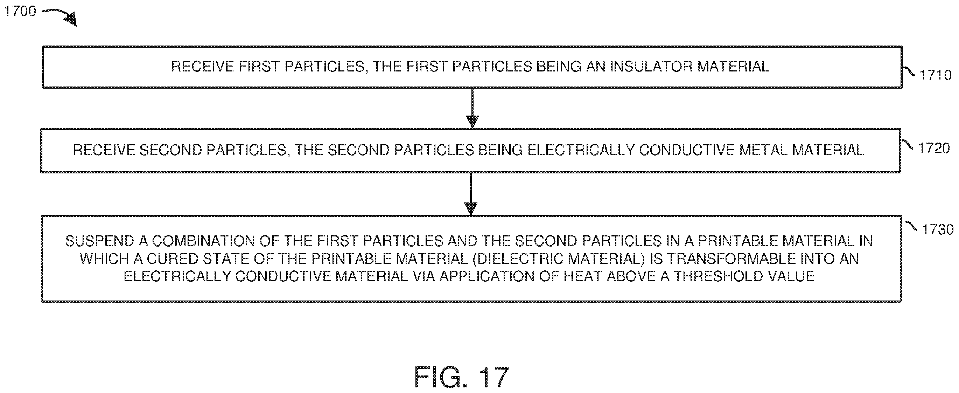

Functionality supported by the different resources will now be discussed via flowcharts in FIGS. 17, 18, and 19. Note that the steps in the flowcharts below can be executed in any suitable order.

FIG. 17 is an example diagram illustrating a method according to embodiments herein.

In processing operation 1710, the control system 140 receives first particles 121 such as insulator material.

In processing operation 1720, the control system 140 receives second particles 122 such as electrically conductive metal material.

In processing operation 1730, the control system 140 suspends a combination of the first particles 121 and the second particles 122 in a printable material (such as mixture 152) in which a cured state of the printable material is transformable into an electrically conductive material via application of heat above a threshold value.

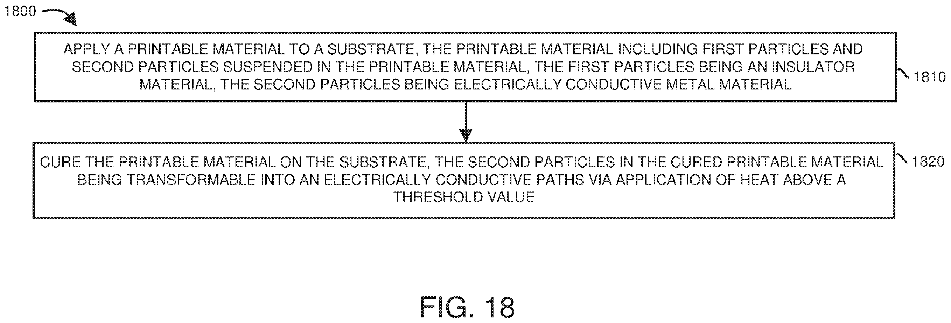

FIG. 18 is an example diagram illustrating a method according to embodiments herein.

In processing operation 1810, the fabrication system 155 applies a printable material (a mixture 152) to a substrate 250. The printable material (mixture 152) includes first particles 121 and second particles 122 suspended in the printable material. In one embodiment, the first particles 121 is an insulator material; the second particles is electrically conductive metal material.

In processing operation 1820, the fabrication system 155 cures the printable material (dielectric material 270) on the substrate 250. The second particles 122 in the cured printable material (dielectric material 270) is transformable into one or more electrically conductive paths via application of heat above a threshold value.

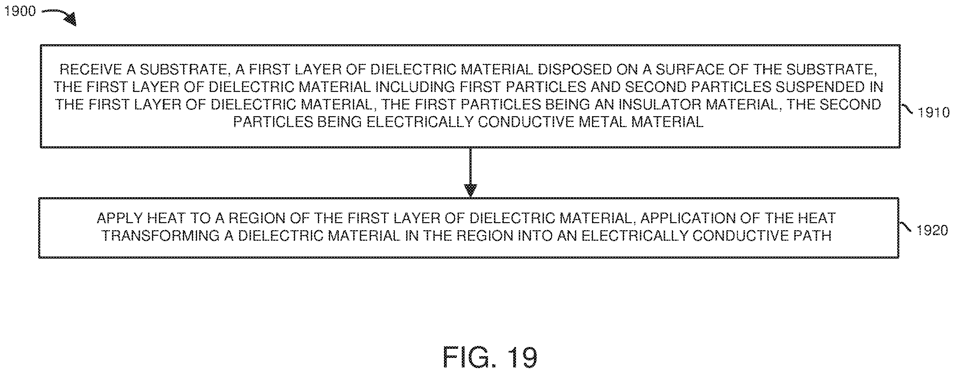

FIG. 19 is an example diagram illustrating a method according to embodiments herein.

In processing operation 1910, the fabricator 240 receives a substrate 250. A first layer of dielectric material 270 is disposed on a surface 420 of the substrate 250. The first layer of dielectric material 270 includes first particles 121 and second particles 122 suspended in the first layer of dielectric material 270. As previously discussed, in one embodiment, the first particles 121 are fabricated from an insulator material; the second particles 122 is fabricated from electrically conductive material 122.

In processing operation 1920, via control of source 230, the fabricator 140 applies heat to a region 250-2 of the first layer of dielectric material 270. Application of the heat (such as via signal 231) transforms the dielectric material 270 in the region 250-2 into an electrically conductive path 260.

Note again that techniques herein are well suited to facilitate fabrication and use of dielectric material ink. However, it should be noted that embodiments herein are not limited to use in such applications and that the techniques discussed herein are well suited for other applications as well.

## Claims

1. A compound comprising:
first particles (121), the first particles (121) being insulator material;
second particles (122), the second particles(122) being electrically conductive material; and
a combination of the first particles (121) and the second particles (122) distributed and suspended in a printable liquid material, a cured state of the printable liquid material being a dielectric material transformable into an electrically conductive paths via application of heat above a threshold value,
wherein the second particles (122) are silver nanoparticles;
wherein the first particles (121) are BST (Barium Strontium Titanate) particles, the compound further comprising:
at least one solvent.

2. The compound as in claim 1, wherein a ratio of the silver particles to the first particles (121) in the printable liquid material is approximately 67 % (+/-20%) of silver to 33% (+/- 20%) of first particles (121) by weigh .

3. The compound as in claim 1, wherein a ratio of the first particles (121) to the second particles (122) is selected such that a group of the second particles (122) in the cured printable material are isolated from each other prior to application of the heat above the threshold value to the group of second particles (122); and
preferably, wherein exposure of the dielectric material to heat above the threshold value causes contact amongst the second particles (122) in the group, the heat converting a portion of the cured printable material into an electrically conductive path.

4. The compound as in claim 1,
wherein the at least one solvent includes:
1-methoxy-2-propanol; and
ethylene glycol, the compound being made up of more than 40% by weight of ethylene glycol; or
wherein the first particles (121) make up approximately 21% of the compound by weight;
wherein the second particles (122) make up approximately 12.5% of the compound by weight; and
wherein the at least one solvent makes up approximately 66.5% of the compound by weight.

5. A method comprising:
receiving first particles (121), the first particles (121) being an insulator material;
receiving second particles (122), the second particles (122) being electrically conductive metal material; and
suspending a combination of the first particles (121) and the second particles (122) in a printable material in which a cured state of the printable material is transformable into an electrically conductive material via application of heat above a threshold value, wherein the second particles (122) are silver nanoparticles;
wherein the first particles (121) are BST (Barium Strontium Titanate) nanoparticles, the compound further comprising:
at least one solvent.

6. The method as in claim 5, wherein a ratio of the silver nanoparticles to the first particles (121) is approximately 67% (+/- 20%) to 33% (+/- 20%) by weight; and
preferably, wherein the printable material is a dielectric material.

7. The compound as in claim 1 or the method as in claim 5, wherein a melting point of the second particles (122) is lower than a melting point of the first particles (121).

8. The method as in claim 5 further comprising:
controlling a ratio of mixing the first particles (121) to the second particles (122) in the printable material such that a group of the second particles (122) in a layer of the printable material are isolated from each other prior to application of heat to the group of second particles (122) above the threshold value; and
preferably, wherein exposure of the printable material to heat above the threshold value causes contact amongst the second particles (122) in the group, the heat converting the dielectric material into an electrically conductive path.

9. The method as in claim 5, wherein the at least one solvent includes:
1-methoxy-2-propanol; and
ethylene glycol, the compound being made up of more than 40% by weight of ethylene glycol; or
wherein the first particles (121) make up substantially 21% (+/- 20%) of the compound by weight;
wherein the second particles (122) make up approximately 12.5% (+/-20%) of the compound by weight; and
wherein the mixture of solvents makes up approximately 66.5% (+/-20%) of the compound by weight.

10. An apparatus comprising:
a substrate;
printed material disposed on the substrate, the printed material including first particles (121) and second particles (122), the first particles (121) being an insulator material, the second particles (122) being electrically conductive metal material; and
the first particles (121) and second particles (122) being randomly distributed in the printed material, the second particles (122) further being transformable into an electrically conductive paths via application of heat above a threshold value due to sintering of silver nanoparticles,
wherein the second particles (122) are silver nanoparticles; and
wherein the first particles (121) are BST (Barium Strontium Titanate) nanoparticles, the printed material further comprising:
at least one solvent.

11. The apparatus as in claim 10, wherein the printed material includes a first portion and a second portion, the first portion of the printed material including second particles (122) that have been sintered via application of heat, the second portion of the printed material including second particles (122) that have not been sintered via application of heat.

12. The apparatus as in claim 10, wherein the printed material on the substrate is a dielectric material.

13. The apparatus as in claim 10, wherein the second particles (122) in the printed material are separated from each other by the first particles (121) prior to application of the heat; and
preferably, wherein the application of the heat to the group of second particles (122) above the threshold value causes physical contact amongst the group of second particles (122) due to the sintering of silver nanoparticles.

14. The apparatus as in claim 10, wherein the at least one solvent includes:
1-methoxy-2-propanol; and
ethylene glycol, the printed material being made up of more than 40% by weight of ethylene glycol.

15. The apparatus as in claim 10, wherein a ratio of the first particles (121) to the second particles (122) is approximately 62.5 (+/- 20%) to 37.5 (+/- 20%).

16. The method of claim 5 further comprising:
applying the printable material to a substrate and
curing the printable material on the substrate, the second particles (122) in the cured printable material being transformable into an electrically conductive paths via application of heat above a threshold value.

17. The method as in claim 16, wherein a group of the second particles (122) in the cured printable material are isolated from each other prior to application of heat to the group of second particles (122) above a threshold value.

18. The method as in claim 16 further comprising:
applying heat to the group of second particles (122) disposed in the dielectric layer of material on the substrate, application of the heat to the group causing the group of second particles (122) to form an electrically conductive paths on the substrate through the layer of dielectric material.

19. The method as in claim 16, wherein applying the heat includes sintering the second particles (122).

20. The method as in claim 17, wherein the at least one solvent includes:
1-methoxy-2-propanol; and
ethylene glycol, the printed material being made up of more than 40% by weight of ethylene glycol; or
wherein the first particles (121) make up approximately 21% of the printed material by weight;
wherein the second particles (122) make up approximately 12.5% of the printed material by weight; and
wherein the mixture of solvents makes up approximately 66.5% of the printed material by weight.

21. The method according to claim 5 further comprising:
receiving a substrate, a first layer of dielectric material disposed on a surface of the substrate, the first layer of dielectric material including the first particles (121) and the second particles (122) suspended in the first layer of dielectric material, the first particles (121) being an insulator material, the second particles (122) being electrically conductive metal material; and
applying heat to a region of the first layer of dielectric material, application of the heat transforming a dielectric material in the region into an electrically conductive path.

22. The method as in claim 21, wherein applying heat to the region of the first layer of dielectric material includes steering a laser beam to the region.

23. The method as in claim 21, wherein applying heat to a region of the first layer of dielectric material includes:
controlling a magnitude of the heat applied to the region depending on a desired resistance of the electrically conductive path.

24. The method as in claim 21, further comprising:
applying a second layer of dielectric material on the first layer of dielectric material, the second layer of dielectric material including first particles (121) and second particles (122) suspended in the second layer of dielectric material, the first particles (121) in the second layer of dielectric material being an insulator material, the second particles (122) in the second layer of dielectric material being electrically conductive material; and
preferably, further comprising:
applying heat to the second layer of dielectric material, application of the heat to the second layer of dielectric material transforming a portion of dielectric material in the second layer of dielectric material from insulator material to an electrically conductive path.

25. An apparatus according to claim 10, wherein the printed material comprises::
a first layer of dielectric material, the first layer of dielectric material including first particles (121) and second particles (122) suspended in the first layer of dielectric material, the first particles (121) being an insulator material, the second particles (122) being electrically conductive metal material; and
a region of the first layer of dielectric material transformed from a dielectric material into an electrically conductive path via application of heat,

26. The apparatus as in claim 25, wherein the region of the first layer of dielectric material includes sintered second particles (122).

27. The apparatus as in claim 25, wherein a set of the second particles (122) in the region contact each other, creating the electrically conductive path.

28. The method as in claim 21 or the apparatus as in claim 25, wherein the first layer of dielectric material includes a set of second particles (122) in the region, the set of second particles (122) being non-contiguous prior to application of the heat; and
wherein the application of the heat above a threshold value causes a sequence of the second particles (122) in the region to electrically contact each other, the contact of the sequence of second particles (122) in the region being an electrically conductive path.

29. The method as in claim 21 or the apparatus as in claim 25, wherein a group of the second particles (122) in the region are of a first grain size prior to application of the heat; and
wherein the group of the second particles (122) in the region are of a second grain size subsequent to the application of the heat, the second grain size larger than the first grain size.

30. The apparatus as in claim 25, wherein the region of the first layer of dielectric material is sintered via a laser beam applied to the region.

31. The method as in claim 21 or the apparatus as in claim 25, wherein the region is a via extending between a first surface of the first layer of dielectric material and a second surface of the first layer of dielectric material.

32. The apparatus as in claim 25 further comprising:
a second layer of dielectric material disposed on the first layer of dielectric material, the second layer of dielectric material including first particles (121) and second particles (122) suspended in the second layer of dielectric material, the first particles (121) in the second layer of dielectric material being an insulator material, the second particles (122) in the second layer of dielectric material being electrically conductive material; and
preferably, wherein application of heat to the second layer of dielectric material transforms a portion of dielectric material in the second layer of dielectric material from insulator material to an electrically conductive path.

33. The method as in claim 21 or the apparatus as in claim 25, wherein application of the heat to the region of the first layer of dielectric material creates an electronic component.

## Patentansprüche

1. Verbindung, umfassend:
erste Partikel (121), wobei die ersten Partikel (121) aus Isoliermaterial bestehen;
zweite Partikel (122), wobei die zweiten Partikel (122) aus elektrisch leitfähigem Material bestehen; und
eine Kombination der ersten Partikel (121) und der zweiten Partikel (122), die in einem druckbaren flüssigen Material verteilt und suspendiert sind, wobei ein gehärteter Zustand des druckbaren flüssigen Materials ein dielektrisches Material ist, das durch Anwendung von Wärme oberhalb eines Schwellenwerts in elektrisch leitfähige Pfade umwandelbar ist, wobei die zweiten Partikel (122) Silbernanopartikel sind;
wobei die ersten Partikel (121) BST(Barium-Strontium-Titanat)-Partikel sind, wobei die Verbindung ferner Folgendes umfasst:
mindestens ein Lösungsmittel.

2. Verbindung nach Anspruch 1, wobei das Verhältnis der Silberpartikel zu den ersten Partikeln (121) in dem druckbaren flüssigen Material etwa 67 Gew.-% (+/- 20 %) Silber zu 33 Gew.-% (+/- 20 %) der ersten Partikel (121) beträgt.

3. Verbindung nach Anspruch 1, wobei ein Verhältnis der ersten Partikel (121) zu den zweiten Partikeln (122) so ausgewählt ist, dass eine Gruppe der zweiten Partikeln (122) in dem gehärteten druckbaren Material vor der Anwendung der Wärme oberhalb des Schwellenwerts auf die Gruppe der zweiten Partikeln (122) voneinander isoliert sind; und
vorzugsweise, wobei die Aussetzung des dielektrischen Materials gegenüber Wärme oberhalb des Schwellenwerts einen Kontakt zwischen den zweiten Partikeln (122) in der Gruppe verursacht, wobei die Wärme einen Teil des gehärteten druckbaren Materials in einen elektrisch leitfähigen Pfad umwandelt.

4. Verbindung nach Anspruch 1,
wobei das mindestens eine Lösungsmittel Folgendes beinhaltet:
1-Methoxy-2-propanol; und
Ethylenglykol, wobei die Verbindung zu mehr als 40 Gew.-% aus Ethylenglykol besteht; oder
wobei die ersten Partikel (121) etwa 21 Gew.-% der Verbindung ausmachen;
wobei die zweiten Partikel (122) etwa 12,5 Gew.-% der Verbindung ausmachen; und
wobei das mindestens eine Lösungsmittel etwa 66,5 Gew.-% der Verbindung ausmacht.

5. Verfahren, umfassend:
Aufnehmen erster Partikel (121), wobei die ersten Partikel (121) aus einem Isoliermaterial bestehen;
Aufnehmen zweiter Partikel (122), wobei die zweiten Partikel (122) aus elektrisch leitendem Metallmaterial bestehen; und Suspendieren einer Kombination aus den ersten Partikeln (121) und den zweiten Partikeln (122) in einem druckbaren Material,
wobei ein gehärteter Zustand des druckbaren Materials durch Anwendung von Wärme oberhalb eines Schwellenwerts in ein elektrisch leitfähiges Material umwandelbar ist, wobei die zweiten Partikel (122) Silbernanopartikel sind;
wobei die ersten Partikel (121) BST(Barium-Strontium-Titanat)-Nanopartikel sind, wobei die Verbindung ferner Folgendes umfasst:
mindestens ein Lösungsmittel.

6. Verfahren nach Anspruch 5, wobei das Verhältnis der Silbernanopartikel zu den ersten Partikeln (121) etwa 67 Gew.-% (+/- 20 %) bis 33 Gew.-% (+/- 20 %) beträgt; und vorzugsweise, wobei das druckbare Material ein dielektrisches Material ist.

7. Verbindung nach Anspruch 1 oder Verfahren nach Anspruch 5, wobei ein Schmelzpunkt der zweiten Partikel (122) niedriger ist als ein Schmelzpunkt der ersten Partikel (121).

8. Verfahren nach Anspruch 5, ferner umfassend:
Steuern eines Mischungsverhältnisses der ersten Partikel (121) zu den zweiten Partikeln (122) in dem druckbaren Material, sodass eine Gruppe der zweiten Partikeln (122) in einer Schicht des druckbaren Material vor der Anwendung von Wärme auf die Gruppe der zweiten Partikeln (122) oberhalb des Schwellenwerts voneinander isoliert sind; und
vorzugsweise, wobei die Aussetzung des druckbaren Materials gegenüber Wärme oberhalb des Schwellenwerts einen Kontakt zwischen den zweiten Partikeln (122) in der Gruppe verursacht, wobei die Wärme das dielektrische Material in einen elektrisch leitfähigen Pfad umwandelt.

9. Verfahren nach Anspruch 5, wobei das mindestens eine Lösungsmittel Folgendes beinhaltet:
1-Methoxy-2-propanol; und
Ethylenglykol, wobei die Verbindung zu mehr als 40 Gew.-% aus Ethylenglykol besteht; oder
wobei die ersten Partikel (121) im Wesentlichen 21 Gew.-% (+/-20 %) der Verbindung ausmachen;
wobei die zweiten Partikel (122) etwa 12,5 Gew.-% (+/- 20 %) der Verbindung ausmachen; und
wobei das Lösungsmittelgemisch etwa 66,5 Gew.-% (+/- 20%) der Verbindung ausmacht.

10. Vorrichtung, umfassend:
ein Substrat;
gedrucktes Material, das auf dem Substrat angeordnet ist,
wobei das gedruckte Material erste Partikel (121) und zweite Partikel (122) beinhaltet, wobei die ersten Partikel (121) aus einem Isolatormaterial und die zweiten Partikel (122) aus einem elektrisch leitenden Metallmaterial bestehen; und
wobei die ersten Partikel (121) und die zweiten Partikel (122) zufällig in dem gedruckten Material verteilt sind, wobei die zweiten Partikel (122) ferner durch Anwendung von Wärme oberhalb eines Schwellenwerts aufgrund von Sintern von Silbernanopartikeln in einen elektrisch leitfähigen Pfad umwandelbar sind,
wobei die zweiten Partikel (122) Silbernanopartikel sind; und
wobei die ersten Partikel (121) BST(Barium-Strontium-Titanat)-Nanopartikel sind, wobei das gedruckte Material ferner Folgendes umfasst:
mindestens ein Lösungsmittel.

11. Vorrichtung nach Anspruch 10, wobei das gedruckte Material einen ersten Teil und einen zweiten Teil aufweist, wobei der erste Teil des gedruckten Materials zweite Partikel (122) beinhaltet, die durch Anwendung von Wärme gesintert wurden, und der zweite Teil des gedruckten Materials zweite Partikel (122) beinhaltet, die nicht durch Anwendung von Wärme gesintert wurden.

12. Vorrichtung nach Anspruch 10, wobei das gedruckte Material auf dem Substrat ein dielektrisches Material ist.

13. Vorrichtung nach Anspruch 10, wobei die zweiten Partikel (122) in dem gedruckten Material durch die ersten Partikel (121) vor der Anwendung der Wärme voneinander getrennt werden; und
vorzugsweise, wobei die Anwendung der Wärme auf die Gruppe der zweiten Partikel (122) oberhalb des Schwellenwerts einen physischen Kontakt zwischen der Gruppe der zweiten Partikel (122) aufgrund des Sinterns der Silbernanopartikel verursacht.

14. Vorrichtung nach Anspruch 10, wobei das mindestens eine Lösungsmittel Folgendes beinhaltet:
1-Methoxy-2-propanol; und
Ethylenglykol, wobei das gedruckte Material zu mehr als 40 Gew.-% aus Ethylenglykol besteht.

15. Vorrichtung nach Anspruch 10, wobei das Verhältnis der ersten Partikel (121) zu den zweiten Partikeln (122) ungefähr 62,5 (+/- 20 %) zu 37,5 (+/- 20 %) beträgt.

16. Verfahren nach Anspruch 5, ferner umfassend:
Anwenden des druckbaren Materials auf ein Substrat und
Aushärten des druckbaren Materials auf dem Substrat, wobei die zweiten Partikel (122) in dem gehärteten druckbaren Material durch Anwendung von Wärme oberhalb eines Schwellenwerts in einen elektrisch leitfähigen Pfad umwandelbar sind.

17. Verfahren nach Anspruch 16, wobei eine Gruppe der zweiten Partikel (122) in dem gehärteten druckbaren Material vor der Anwendung von Wärme auf die Gruppe der zweiten Partikel (122) oberhalb eines Schwellenwerts voneinander isoliert wird.

18. Verfahren nach Anspruch 16, ferner umfassend:
Anwenden von Wärme auf die Gruppe von zweiten Partikeln (122), die in der dielektrischen Materialschicht auf dem Substrat angeordnet sind, wobei das Anwenden der Wärme auf die Gruppe bewirkt, dass die Gruppe von zweiten Partikeln (122) einen elektrisch leitfähigen Pfad auf dem Substrat durch die Schicht aus dielektrischem Material bildet.

19. Verfahren nach Anspruch 16, wobei die Anwendung der Wärme das Sintern der zweiten Partikel (122) beinhaltet.

20. Verfahren nach Anspruch 17, wobei das mindestens eine Lösungsmittel Folgendes beinhaltet:
1-Methoxy-2-propanol; und
Ethylenglykol, wobei das gedruckte Material zu mehr als 40 Gew.-% aus Ethylenglykol besteht; oder
wobei die ersten Partikel (121) etwa 21 Gew.-% des gedruckten Materials ausmachen;
wobei die zweiten Partikel (122) etwa 12,5 Gew.-% des gedruckten Materials ausmachen; und
wobei das Lösungsmittelgemisch etwa 66,5 Gew.-% des gedruckten Materials ausmacht.

21. Verfahren nach Anspruch 5, ferner umfassend:
Aufnehmen eines Substrats, einer ersten Schicht aus dielektrischem Material, die auf einer Oberfläche des Substrats angeordnet ist, wobei die erste Schicht aus dielektrischem Material die ersten Partikel (121) und die zweiten Partikel (122) beinhaltet, die in der ersten Schicht aus dielektrischem Material suspendiert sind, wobei die ersten Partikel (121) aus einem Isolatormaterial bestehen und die zweiten Partikel (122) aus einem elektrisch leitenden Metallmaterial bestehen; und
Anwenden von Wärme auf einen Bereich der ersten Schicht aus dielektrischem Material, wobei die Anwendung der Wärme ein dielektrisches Material in dem Bereich in einen elektrisch leitfähigen Pfad umwandelt.

22. Verfahren nach Anspruch 21, wobei das Anwenden von Wärme auf den Bereich der ersten Schicht aus dielektrischem Material Lenken eines Laserstrahls auf den Bereich beinhaltet.

23. Verfahren nach Anspruch 21, wobei das Anwenden von Wärme auf einen Bereich der ersten Schicht aus dielektrischem Material Folgendes beinhaltet:
Steuern einer Stärke der auf den Bereich angewendeten Wärme in Abhängigkeit von einem gewünschten Widerstand des elektrisch leitenden Pfades.

24. Verfahren nach Anspruch 21, ferner umfassend:
Anwenden einer zweiten Schicht aus dielektrischem Material auf die erste Schicht aus dielektrischem Material, wobei die zweite Schicht aus dielektrischem Material erste Partikel (121) und zweite Partikel (122) beinhaltet, die in der zweiten Schicht aus dielektrischem Material suspendiert sind, wobei die ersten Partikel (121) in der zweiten Schicht aus dielektrischem Material aus einem Isolatormaterial bestehen und die zweiten Partikel (122) in der zweiten Schicht aus dielektrischem Material aus einem elektrisch leitfähigen Material bestehen; und
vorzugsweise, ferner umfassend:
Anwenden von Wärme auf die zweite Schicht aus dielektrischem Material, wobei die Anwendung der Wärme auf die zweite Schicht aus dielektrischem Material einen Teil des dielektrischen Materials in der zweiten Schicht aus dielektrischem Material von Isoliermaterial in einen elektrisch leitfähigen Pfad umwandelt.

25. Vorrichtung nach Anspruch 10, wobei das gedruckte Material Folgendes umfasst:
eine erste Schicht aus dielektrischem Material, wobei die erste Schicht aus dielektrischem Material erste Partikel (121) und zweite Partikel (122) beinhaltet, die in der ersten Schicht aus dielektrischem Material suspendiert sind, wobei die ersten Partikel (121) aus einem Isolatormaterial bestehen und die zweiten Partikel (122) aus einem elektrisch leitenden Metallmaterial bestehen; und
einen Bereich der ersten Schicht aus dielektrischem Material, der durch Anwendung von Wärme von einem dielektrischen Material in einen elektrisch leitfähigen Pfad umwandelbar ist.

26. Vorrichtung nach Anspruch 25, wobei der Bereich der ersten Schicht aus dielektrischem Material gesinterte zweite Partikel (122) beinhaltet.

27. Vorrichtung nach Anspruch 25, wobei ein Satz der zweiten Partikel (122) in dem Bereich einander berührt, wodurch der elektrisch leitfähige Pfad entsteht.

28. Verfahren nach Anspruch 21 oder Vorrichtung nach Anspruch 25, wobei die erste Schicht aus dielektrischem Material einen Satz zweiter Partikel (122) in dem Bereich beinhaltet, wobei der Satz zweiter Partikel (122) vor der Anwendung der Wärme nicht aneinandergrenzt; und
wobei die Anwendung der Wärme oberhalb eines Schwellenwertes bewirkt, dass eine Folge der zweiten Partikel (122) in dem Bereich elektrisch miteinander in Kontakt tritt, wobei der Kontakt der Folge der zweiten Partikel (122) in dem Bereich ein elektrisch leitfähiger Pfad ist.

29. Verfahren nach Anspruch 21 oder Vorrichtung nach Anspruch 25, wobei eine Gruppe der zweiten Partikel (122) in dem Bereich vor der Anwendung der Wärme eine erste Korngröße aufweist; und
wobei die Gruppe der zweiten Partikel (122) in dem Bereich nach der Anwendung der Wärme eine zweite Korngröße aufweist, wobei die zweite Korngröße größer ist als die erste Korngröße.

30. Vorrichtung nach Anspruch 25, wobei der Bereich der ersten Schicht aus dielektrischem Material mittels eines auf den Bereich angewendeten Laserstrahls gesintert wird.

31. Verfahren nach Anspruch 21 oder Vorrichtung nach Anspruch 25, wobei der Bereich eine Durchkontaktierung ist, die sich zwischen einer ersten Oberfläche der ersten Schicht aus dielektrischem Material und einer zweiten Oberfläche der ersten Schicht aus dielektrischem Material erstreckt.

32. Vorrichtung nach Anspruch 25, ferner umfassend:
eine zweite Schicht aus dielektrischem Material, die auf der ersten Schicht aus dielektrischem Material angeordnet, wobei die zweite Schicht aus dielektrischem Material erste Partikel (121) und zweite Partikel (122) beinhaltet, die in der zweiten Schicht aus dielektrischem Material suspendiert sind, wobei die ersten Partikel (121) in der zweiten Schicht aus dielektrischem Material aus einem Isolatormaterial bestehen und die zweiten Partikel (122) in der zweiten Schicht aus dielektrischem Material aus einem elektrisch leitfähigen Material bestehen; und
vorzugsweise, wobei die Anwendung von Wärme auf die zweite Schicht aus dielektrischem Material einen Teil des dielektrischen Materials in der zweiten Schicht aus dielektrischem Material von Isoliermaterial in einen elektrisch leitfähigen Pfad umwandelt.

33. Verfahren nach Anspruch 21 oder Vorrichtung nach Anspruch 25, wobei durch Anwendung der Wärme auf den Bereich der ersten Schicht des dielektrischen Materials eine elektronische Komponente entsteht.

## Revendications

1. Composé comprenant :
des premières particules (121), les premières particules (121) étant un matériau isolant ;
des secondes particules (122), les secondes particules (122) étant un matériau électriquement conducteur ; et
une combinaison des premières particules (121) et des secondes particules (122) réparties et en suspension dans un matériau liquide imprimable, un état durci du matériau liquide imprimable étant un matériau diélectrique transformable en chemins électriquement conducteurs via l'application de chaleur au-dessus d'une valeur seuil,
dans lequel les secondes particules (122) sont des nanoparticules d'argent ;
dans lequel les premières particules (121) sont des particules de BST (Titanate de Baryum Strontium), le composé comprenant en outre :
au moins un solvant.

2. Composé selon la revendication 1, dans lequel un rapport des particules d'argent aux premières particules (121) dans le matériau liquide imprimable est d'environ 67 % (+/- 20 %) d'argent à 33 % (+/- 20 %) des premières particules (121) en poids.

3. Composé selon la revendication 1, dans lequel un rapport des premières particules (121) aux secondes particules (122) est choisi de telle sorte qu'un groupe des secondes particules (122) dans le matériau imprimable durci soit isolé les unes des autres avant l'application de la chaleur au-dessus de la valeur seuil au groupe de secondes particules (122) ; et
de préférence, dans lequel l'exposition du matériau diélectrique à de la chaleur supérieure à la valeur seuil entraîne un contact entre les secondes particules (122) du groupe, la chaleur convertissant une partie du matériau imprimable durci en un trajet électriquement conducteur.

4. Composé selon la revendication 1,
dans lequel l'au moins un solvant comprend :
du 1-méthoxy-2-propanol ; et
de l'éthylène glycol, le composé étant constitué de plus de 40 % en poids d'éthylène glycol ; ou
dans lequel les premières particules (121) représentent environ 21 % du composé en poids ;
dans lequel les secondes particules (122) représentent environ 12,5 % du composé en poids ; et
dans lequel l'au moins un solvant représente environ 66,5 % du composé en poids.

5. Procédé comprenant :
la réception de premières particules (121), les premières particules (121) étant un matériau isolant ;
la réception de secondes particules (122), les secondes particules (122) étant un matériau métallique électriquement conducteur ; et
la mise en suspension d'une combinaison des premières particules (121) et des secondes particules (122) dans un matériau imprimable dans lequel un état durci du matériau imprimable peut être transformé en un matériau électriquement conducteur via l'application de chaleur au-dessus d'une valeur seuil, dans lequel les secondes particules (122) sont des nanoparticules d'argent ;
dans lequel les premières particules (121) sont des nanoparticules de BST (Titanate de Baryum Strontium), le composé comprenant en outre :
au moins un solvant.

6. Procédé selon la revendication 5, dans lequel un rapport des nanoparticules d'argent aux premières particules (121) est d'environ 67 % (+/- 20 %) à 33 % (+/- 20 %) en poids ; et
de préférence, dans lequel le matériau imprimable est un matériau diélectrique.

7. Composé selon la revendication 1 ou procédé selon la revendication 5, dans lequel le point de fusion des secondes particules (122) est inférieur au point de fusion des premières particules (121).

8. Procédé selon la revendication 5, comprenant en outre :
le contrôle d'un rapport de mélange des premières particules (121) aux secondes particules (122) dans le matériau imprimable de telle sorte qu'un groupe des secondes particules (122) dans une couche du matériau imprimable soit isolé les unes des autres avant l'application de chaleur au groupe de secondes particules (122) au-dessus de la valeur seuil ; et
de préférence, dans lequel l'exposition du matériau imprimable à de la chaleur au-dessus de la valeur seuil entraîne un contact entre les secondes particules (122) du groupe, la chaleur convertissant le matériau diélectrique en un trajet électriquement conducteur.

9. Procédé selon la revendication 5, dans lequel l'au moins un solvant comprend :
du 1-méthoxy-2-propanol ; et
de l'éthylène glycol, le composé étant constitué de plus de 40 % en poids d'éthylène glycol ; ou
dans lequel les premières particules (121) représentent pratiquement 21 % (+/- 20 %) du composé en poids ;
dans lequel les secondes particules (122) représentent environ 12,5 % (+/- 20 %) du composé en poids ; et
dans lequel le mélange de solvants représente environ 66,5 % (+/- 20 %) du composé en poids.

10. Appareil comprenant :
un substrat ;
un matériau imprimé disposé sur le substrat, le matériau imprimé comprenant des premières particules (121) et des secondes particules (122), les premières particules (121) étant un matériau isolant, les secondes particules (122) étant un matériau métallique électriquement conducteur ; et
les premières particules (121) et les secondes particules (122) étant réparties de manière aléatoire dans le matériau imprimé,
les secondes particules (122) étant en outre transformables en chemins électriquement conducteurs via l'application de chaleur au-dessus d'une valeur seuil due au frittage de nanoparticules d'argent,
dans lequel les secondes particules (122) sont des nanoparticules d'argent ; et
dans lequel les premières particules (121) sont des nanoparticules de BST (Titanate de Baryum Strontium), le matériau imprimé comprenant en outre :
au moins un solvant.

11. Appareil selon la revendication 10, dans lequel le matériau imprimé comprend une première partie et une seconde partie, la première partie du matériau imprimé comprenant des secondes particules (122) qui ont été frittées par application de chaleur, la seconde partie du matériau imprimé comprenant des secondes particules (122) qui n'ont pas été frittées par application de chaleur.

12. Appareil selon la revendication 10, dans lequel le matériau imprimé sur le substrat est un matériau diélectrique.

13. Appareil selon la revendication 10, dans lequel les secondes particules (122) dans le matériau imprimé sont séparées les unes des autres par les premières particules (121) avant l'application de la chaleur ; et
de préférence, dans lequel l'application de chaleur au groupe de secondes particules (122) au-dessus de la valeur seuil entraîne un contact physique entre le groupe de secondes particules (122) en raison du frittage de nanoparticules d'argent.

14. Appareil selon la revendication 10, dans lequel l'au moins un solvant comprend :
du 1-méthoxy-2-propanol ; et
de l'éthylène glycol, le matériau imprimé étant constitué de plus de 40 % en poids d'éthylène glycol.

15. Appareil selon la revendication 10, dans lequel un rapport des premières particules (121) aux secondes particules (122) est d'environ 62,5 (+/- 20 %) à 37,5 (+/- 20 %).

16. Procédé selon la revendication 5, comprenant en outre :
l'application du matériau imprimable sur un substrat et
le durcissement du matériau imprimable sur le substrat, les secondes particules (122) dans le matériau imprimable durci pouvant être transformées en chemins électriquement conducteurs via l'application de chaleur au-dessus d'une valeur seuil.

17. Procédé selon la revendication 16, dans lequel un groupe des secondes particules (122) dans le matériau imprimable durci est isolé les unes des autres avant l'application de chaleur au groupe de secondes particules (122) au-dessus d'une valeur seuil.

18. Procédé selon la revendication 16, comprenant en outre :
l'application de chaleur au groupe de secondes particules (122) disposé dans la couche de matériau diélectrique sur le substrat, l'application de la chaleur au groupe amenant le groupe de secondes particules (122) à former des trajets électriquement conducteurs sur le substrat à travers la couche de matériau diélectrique.

19. Procédé selon la revendication 16, dans lequel l'application de la chaleur comprend le frittage des secondes particules (122) .

20. Procédé selon la revendication 17, dans lequel l'au moins un solvant comprend :
du 1-méthoxy-2-propanol ; et
de l'éthylène glycol, le matériau imprimé étant constitué de plus de 40 % en poids d'éthylène glycol ; ou
dans lequel les premières particules (121) représentent environ 21 % du matériau imprimé en poids ;
dans lequel les secondes particules (122) représentent environ 12,5 % du matériau imprimé en poids ; et
dans lequel le mélange de solvants représente environ 66,5 % du matériau imprimé en poids.

21. Procédé selon la revendication 5, comprenant en outre :
la réception d'un substrat, d'une première couche de matériau diélectrique disposée sur une surface du substrat, de la première couche de matériau diélectrique comprenant les premières particules (121) et les secondes particules (122) en suspension dans la première couche de matériau diélectrique, les premières particules (121) étant un matériau isolant, les secondes particules (122) étant un matériau métallique électriquement conducteur ; et
l'application de chaleur à une région de la première couche de matériau diélectrique, l'application de la chaleur transformant un matériau diélectrique dans la région en un chemin électriquement conducteur.

22. Procédé selon la revendication 21, dans lequel l'application de chaleur à la région de la première couche de matériau diélectrique comprend l'orientation d'un faisceau laser vers la région.

23. Procédé selon la revendication 21, dans lequel l'application de chaleur à une région de la première couche de matériau diélectrique comprend :
le contrôle d'une ampleur de la chaleur appliquée à la région en fonction d'une résistance souhaitée du chemin électriquement conducteur.

24. Procédé selon la revendication 21, comprenant en outre :
l'application d'une seconde couche de matériau diélectrique sur la première couche de matériau diélectrique, la seconde couche de matériau diélectrique comprenant des premières particules (121) et des secondes particules (122) en suspension dans la seconde couche de matériau diélectrique, les premières particules (121) dans le la seconde couche de matériau diélectrique étant un matériau isolant, les secondes particules (122) dans la seconde couche de matériau diélectrique étant un matériau électriquement conducteur ; et
comprenant en outre de préférence :
l'application de chaleur à la seconde couche de matériau diélectrique, l'application de la chaleur à la seconde couche de matériau diélectrique transformant une partie du matériau diélectrique dans la seconde couche de matériau diélectrique du matériau isolant en un chemin électriquement conducteur.

25. Appareil selon la revendication 10, dans lequel le matériau imprimé comprend :
une première couche de matériau diélectrique, la première couche de matériau diélectrique comprenant des premières particules (121) et des secondes particules (122) en suspension dans la première couche de matériau diélectrique, les premières particules (121) étant un matériau isolant, les secondes particules (122) étant un matériau métallique électriquement conducteur ; et
une région de la première couche de matériau diélectrique étant transformée d'un matériau diélectrique en un chemin électriquement conducteur via l'application de chaleur.

26. Appareil selon la revendication 25, dans lequel la région de la première couche de matériau diélectrique comprend des secondes particules frittées (122).

27. Appareil selon la revendication 25, dans lequel un ensemble de secondes particules (122) dans la région entre en contact les unes avec les autres, créant le chemin électriquement conducteur.

28. Procédé selon la revendication 21 ou appareil selon la revendication 25, dans lequel la première couche de matériau diélectrique comprend un ensemble de secondes particules (122) dans la région, l'ensemble de secondes particules (122) n'étant pas contigu avant l'application de la chaleur ; et
dans lequel l'application de chaleur au-dessus d'une valeur seuil amène une séquence de secondes particules (122) dans la région à entrer en contact électrique les unes avec les autres, le contact de la séquence de secondes particules (122) dans la région étant un chemin électriquement conducteur.

29. Procédé selon la revendication 21 ou appareil selon la revendication 25, dans lequel un groupe des secondes particules (122) dans la région a une première granulométrie avant l'application de la chaleur ; et
dans lequel le groupe des secondes particules (122) dans la région a une seconde granulométrie suite à l'application de la chaleur, la seconde granulométrie étant supérieure à la première granulométrie.

30. Appareil selon la revendication 25, dans lequel la région de la première couche de matériau diélectrique est frittée via un faisceau laser appliqué à la région.

31. Procédé selon la revendication 21 ou appareil selon la revendication 25, dans lequel la région est un trou s'étendant entre une première surface de la première couche de matériau diélectrique et une seconde surface de la première couche de matériau diélectrique.

32. Appareil selon la revendication 25, comprenant en outre :
une seconde couche de matériau diélectrique disposée sur la première couche de matériau diélectrique, la seconde couche de matériau diélectrique comprenant des premières particules (121) et des secondes particules (122) en suspension dans la seconde couche de matériau diélectrique, les premières particules (121) dans la seconde couche de matériau diélectrique étant un matériau isolant, les secondes particules (122) dans la seconde couche de matériau diélectrique étant un matériau électriquement conducteur ; et
de préférence, dans lequel l'application de chaleur à la seconde couche de matériau diélectrique transforme une partie du matériau diélectrique dans la seconde couche de matériau diélectrique d'un matériau isolant en un chemin électriquement conducteur.

33. Procédé selon la revendication 21 ou appareil selon la revendication 25, dans lequel l'application de chaleur à la région de la première couche de matériau diélectrique crée un composant électronique.
